(19)

Europäisches Patentamt
European Patent Office
Office européen des brevets

(11) **EP 3 889 993 A1**

(12) **EUROPEAN PATENT APPLICATION**

(43) Date of publication:
**06.10.2021  Bulletin 2021/40**

(51) Int Cl.:
**H01J 37/04** (2006.01)     **H01J 37/26** (2006.01)

(21) Application number: **21164758.1**

(22) Date of filing: **25.03.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2020   US 202016834963**

(71) Applicant: **FEI Company**
**Hillsboro, OR 97124-5793 (US)**

(72) Inventors:
• **Henstra, Alexander**
  **5602 BS Eindhoven (NL)**
• **Deng, Yuchen**
  **5602 BS Eindhoven (NL)**
• **Kohr, Holger**
  **5602 BS Eindhoven (NL)**
• **Mohammadi-Gheidari, Ali**
  **5602 BS Eindhoven (NL)**

(74) Representative: **Janssen, Francis-Paul**
**FEI Company**
**Patent Department**
**P.O.Box 1745**
**5602 BS Eindhoven (NL)**

(54) **DUAL BEAM BIFOCAL CHARGED PARTICLE MICROSCOPE**

(57)    Methods and systems for investigating a sample using a dual beam bifocal charged particle microscope, according to the present disclosure include emitting a plurality of charged particles toward the sample, forming the plurality of charged particles into a first charged particle beam and a second charged particle beam, and modifying the focal properties of at least one of the first charged particle beam and the second charged particle beam. The focal properties of at least one of the first charged particle beam and the second charged particle beam is modified such that the corresponding focal planes of the first charged particle beam and the second charged particle beam are different.

FIG. 1

EP 3 889 993 A1

**Description**

BACKGROUND OF THE INVENTION

Charged particle microscope systems have been developed to allow scientists to investigate and gather information on how microscopic systems work. In pursuit of such knowledge, scientists push the limits of what current charged particle microscope systems are able to investigate. Though charged particle microscopes continue to evolve to have improved investigative power, we will eventually push the limits of what is achievable with current microscope setups. As these limits begin to be reached, there is a need for new types of charged particle microscopes.

SUMMARY OF THE INVENTION

Methods for using a dual beam bifocal charged particle microscope to investigate a sample, according to the present disclosure include the steps of emitting a plurality of charged particles toward the sample, forming the plurality of charged particles into a first charged particle beam and a second charged particle beam, and modifying the focal plane of at least one of the first charged particle beam and the second charged particle beam such that corresponding focal planes of the first charged particle beam and the second charged particle beam are different. For example, in some embodiments, the focal plane of at least one of the first charged particle beam and the second charged particle beam is modified such that the first charged particle beam is focused at a plane at or near the sample, and the second charged particle beam is not focused at the plane at or near the sample.

Systems for investigating a sample using a dual beam bifocal charged particle microscope, according to the present disclosure comprise a sample holder configured to hold a sample, a charged particle emitter configured to emit charged particles towards the sample, and a bifocal beamformer positioned between the charged particle emitter and the sample holder. The bifocal beamformer is configured to form the plurality of charged particles into a first charged particle beam and a second charged particle beam, and modify the focal properties of at least one of the first charged particle beam and the second charged particle beam. In some embodiments, the bifocal beamformer modifies the focal properties to cause the corresponding focal planes of the first charged particle beam and the second charged particle beam to be different. Alternatively, in other setups the modified focal properties of the first charged particle beam and the second charged particle beam enables another component of the system (e.g., a multipole element, stigmator, etc.) to cause the corresponding focal planes of the first charged particle beam and the second charged particle beam to be different. In some embodiments, the bifocal beamformer modifies the focal properties of at least one of the beams such that the first charged particle beam is focused at a plane at or near the sample and the second charged particle beam is not focused at the plane at or near the sample.

In some embodiments of the present disclosure, a bifocal beamformer corresponds to a MEMS (Micro-Electro-Mechanical System) device that comprises a physical structure that defines a first aperture configured to allow a first portion of charged particles of a plurality of charged particles to pass through the MEMS device, and a second aperture configured to allow a second portion of charged particles of the plurality of charged particles to pass through the MEMS device. Such MEMS devices further include one or more electrodes configured to, when corresponding voltages are applied to the one or more electrodes, generate at least a quadrupole field that causes a modification of the focal properties of at least one of the first portion of charged particles and the second portion of charged particles

In some embodiments of the present disclosure, a bifocal beamformer corresponds to an aperture lens array device that comprises at least one physical structure that defines a first aperture configured to allow a first portion of charged particles of a plurality of charged particles to pass through the aperture lens array device, a second aperture configured to allow a second portion of charged particles of the plurality of charged particles to pass through the aperture lens array device; and plurality of other apertures. Such aperture lens array devices also include at least one electrode. The first aperture, the second aperture, and the plurality of other apertures form a pattern that, when corresponding voltages are applied to the at least one physical structure and the at least one electrode, produces an electromagnetic field that applies a lensing effect to the second portion of charged particles during use of the aperture lens array device. For example, the electromagnetic field may apply a quadrupole lensing effect and/or a round lens effect to one or both of the beams. In some embodiments according to the present disclosure, the aperture lens array applies a first lensing effect to the first portion of charged particles and a second lensing effect that is different from the first lensing effect to the second portion of charged particles.

BRIEF DESCRIPTION OF THE DRAWINGS

The detailed description is described with reference to the accompanying figures. In the figures, the left-most digit(s) of a reference number identify the figure in which the reference number first appears. The same reference numbers in different figures indicates similar or identical items.

Figure 1 illustrates example bifocal multibeam charged particle systems according to the present invention.

Figure 2 illustrates a sample process for investigation of a sample with a bifocal multibeam charged particle system according to the present invention.

Figure 3 illustrates example bifocal multibeam charged particle systems for investigating a sample 104 where the bifocal beamformer comprises a MEMS device.

Figure 4 illustrates an example MEMS device according to the present invention.

Figure 5 illustrates a top down schematic view of an example embodiment of MEMS device that comprises four electrodes.

Figure 6 illustrates a top down schematic view of an example embodiment of MEMS device that comprises seven electrodes.

Figure 7 illustrates the distortion of the second charged particle beam caused when an example embodiment bifocal beamformer causes at least a quadrupole lensing effect to be applied thereto.

Figures 8 and 9 are illustrations of the optical performance of a bifocal multibeam charged particle system according to the present invention.

Figure 10 illustrates example embodiments of bifocal multibeam charged particle systems for investigating a sample where the bifocal beamformer comprises an aperture lens array.

Figure 11 illustrates an example electrode for an example aperture lens array.

Figure 12 illustrates an example aperture defining structure for an example aperture lens array.

Figure 13 illustrates a cross section of an example aperture lens array having one aperture defining structure.

Figures 14-19 illustrate example central structures which can be used in the multiple aperture assembly illustrated in Figure 23.

Figure 23 illustrates a cross section of an example aperture lens array that comprises a first electrode, a second electrode, and an aperture defining structure.

Figure 24 illustrates example embodiments of bifocal multibeam charged particle systems for investigating a sample where the bifocal beamformer comprises a beam splitting mechanism and one or more focusing devices.

Like reference numerals refer to corresponding parts throughout the several views of the drawings. Generally, in the figures, elements that are likely to be included in a given example are illustrated in solid lines, while elements that are optional to a given example are illustrated in broken lines. However, elements that are illustrated in solid lines are not essential to all examples of the present disclosure, and an element shown in solid lines may be omitted from a particular example without departing from the scope of the present disclosure.

DETAILED DESCRIPTION OF EMBODIMENTS

Methods and systems for operating a dual beam bifocal charged particle microscope having a first charged particle beam and a second charged particle beam have different corresponding focal planes, are included herein. More specifically, the methods and systems disclosed herein include and/or are configured to split a plurality of charged particles that have been emitted by a charged particle source into a first charged particle beam and a second charged particle beam, and modifying the focal properties of at least one of the first charged particle beam and the second charged particle beam such that corresponding focal planes of the first charged particle beam and the second charged particle beam are different. For example, in some embodiments, the focal plane of at least one of the first charged particle beam and the second charged particle beam is modified such that the first charged particle beam is focused at a plane at or near the sample, and the second charged particle beam is not focused at the plane at or near the sample. For example, one beam may be caused to have a focal plane at a sample, and the other beam may have a corresponding focal plane at least 0.1%, 1%, 10%, or 100 % of the objective lens focal distance above or below the specimen. Alternatively, or in addition, in a plane where one of the beams is in focus (i.e., at or near a focal plane of the respective beam), the diameter of the other beam may be at least 50, 100, 500, or 1000 times greater than the diameter of the in focus beam. The latter diameter is the so-called geometric spot, which is the virtual source size times the magnification from source to beam focus. For example, the diameter of one beam at the sample may be at least one of 50, 100, 500, or 1000 times greater than the diameter of the other charged particle beam.

In some embodiments, the plurality of charged particles are split and/or modified at least partially by a bifocal beamformer. In some embodiments, the bifocal beamformers cause the focal planes of the two beams to be different. Alternatively, in some embodiments the bifocal beamforms generate at least a quadrupole electromagnetic field that causes a change in the focal properties of at least one of the charged particle beams such that, when the beams are subsequently passed through a multipole element that generates at least a complementary quadrupole electromagnetic field, the corresponding focal planes of the two beams are caused to be different. In such an embodiment, the multipole element may be positioned at or near a focal plane of the other charged particle beam to which the bifocal beamformer does not apply the quadrupole lensing effect. This allows the effects of the complementary quadrupole electromagnetic field on the other beam to be minimized, and it also ensures that the wide beam can be made fully cylindrically symmetric.

In a first exemplary embodiment, the bifocal beamformer may be a microelectromechanical system (MEMS) that comprises a physical structure that defines a first aperture configured to allow a first portion of charged particles of a plurality of charged particles to pass through the MEMS device, and a second aperture configured to allow a second portion of charged particles of the plurality of charged particles to pass through the MEMS device. Such MEMS devices further include one or more electrodes configured to, when corresponding voltages are applied to the one or more electrodes, generate at least a quadrupole field that causes a modification of the focal properties of at least one of the first portion of charged particles and the second portion of charged particles. Additionally, the MEMS devices may further be configured to generate at least a dipole electromagnetic field that causes at least one of the beams to be deflected. For example, a MEMS device may generate a dipole field that applies a deflection force to a charged particle beam in a direction perpendicular to an emission axis of the system.

Alternatively, in a second exemplary embodiment the bifocal beamformer may be an aperture lens array device that comprises at least one physical structure that defines a first aperture configured to allow a first portion of charged particles of a plurality of charged particles to pass through the aperture lens array device, a second aperture configured to allow a second portion of charged particles of the plurality of charged particles to pass through the aperture lens array device; and plurality of other apertures. Such aperture lens array devices also include at least one electrode. The first aperture, the second aperture, and the plurality of other apertures form a pattern that, when corresponding voltages are applied to the at least one physical structure and the at least one electrode, produces an electromagnetic field that applies a lensing effect to the second portion of charged particles during use of the aperture lens array device.

However, Applicant notes that the bifocal beamformers disclosed herein is not limited to these two exemplary embodiments, but may include other structures/systems capable of splitting the plurality of charged particles that have been emitted by a charged particle source into a first charged particle beam and a second charged particle beam, and modifying the focal properties of at least one of the first charged particle beam and the second charged particle beam. Such structures/systems include but are not limited to those including a physical structure that blocks a portion of the plurality of charged particles while allowing others to pass through (e.g., a biprism, a charged wire, an amplitude-division electron beam splitter made of thin crystals or nanofabricated gratings, a beam splitting laser system configured to use one or more lasers pattern fringes to split the plurality of charged particles, etc.) and one or more lenses (e.g., an einzel lens, a quadrupole lens, a cylinder lens, etc.) that are positioned or otherwise configured to cause the two charged particle beams to have different corresponding focal planes.

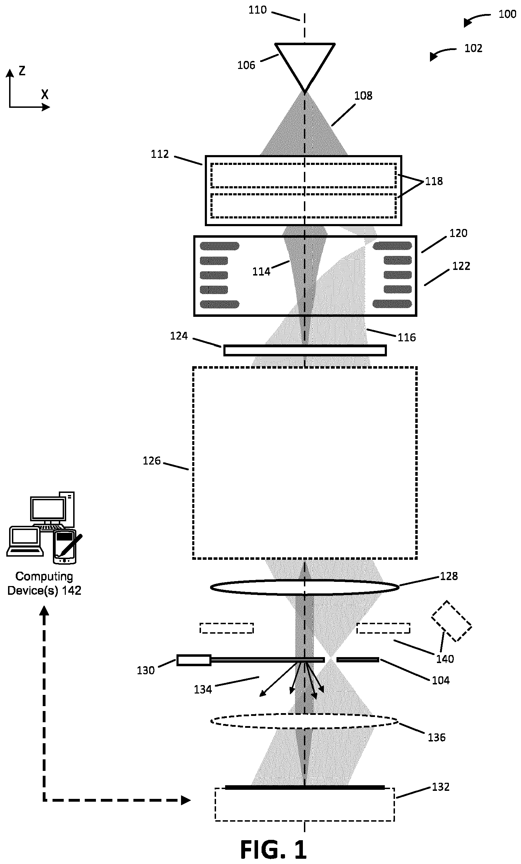

FIG. 1 is an illustration of bifocal multibeam charged particle system(s) 100 according to the present invention. Specifically, FIG. 1 illustrates an example bifocal multibeam charged particle system(s) 102 that is setup for using diffraction holography to investigate a sample 104. However, this setup is merely exemplary, and Applicant notes that bifocal multibeam charged particle system(s) 100 according to the present invention are not limited to such setups.

The example bifocal multibeam charged particle system(s) 102 may include electron microscope (EM) setups, electron lithography setups, or charged particle setups that are configured to irradiate and/or otherwise impinge the sample 104 with at least two beams of electrically charged particles (usually an electron beam or an ion beam) that have different corresponding focal planes. In various embodiments, the example bifocal multibeam charged particle system(s) 102 may be or include one or more different types of EM and/or charged particle microscopes, such as but not limited to, a scanning electron microscope (SEM), a scanning transmission electron microscope (STEM), a transmission electron microscope (TEM), a charged particle microscope (CPM), dual beam microscopy system, etc. Additionally, in some embodiments, a TEM is capable of operating as a STEM as well.

The example bifocal multibeam charged particle system(s) 100 includes a charged particle source 106 (e.g., a thermal electron source, Schottky-emission source, field emission source, a liquid metal ion source, a plasma ion source, etc.) that emits a plurality of charged particles 108 (i.e., a charged particle beam) along an emission axis 110 and towards a bifocal beamformer 112. In embodiments where the charged particle source 106 is an electron source, the plurality of charged particles 108 correspond to a plurality of electrons emitted. Alternatively, where the charged particle source 106 is an ion source, the plurality of charged particles 108 correspond to emitted ions of a corresponding ion species (or combination of ion species). The emission axis 110 is a central axis that runs along the length of the example bifocal multibeam charged particle system(s) 102 from the charged particle source 106 and through the sample 104.

The bifocal beamformer 112 is one or more structures configured to (i) split the plurality of charged particles 108 into at least a first charged particle beam 114 and a second charged particle beam 116, and (ii) modify the focal properties of at least one of the first charged particle beam 114 and a second charged particle beam 116. For example, the bifocal beamformer 112 may modify the focal properties such that the first charged particle beam 114 and a second charged particle beam 116 have different corresponding focal planes. FIG. 1 illustrates the bifocal beamformer 112 as splitting the plurality of charged particles 108 into a first charged particle beam 114 that runs along the emission axis 110 and a second charged particle beam 116. Because each of the first charged particle beam 114 and the second charged particle beam 116 are formed from the plurality of charged particles 106, the first charged particle beam 114 and a second charged particle beam 116 are mutually coherent.

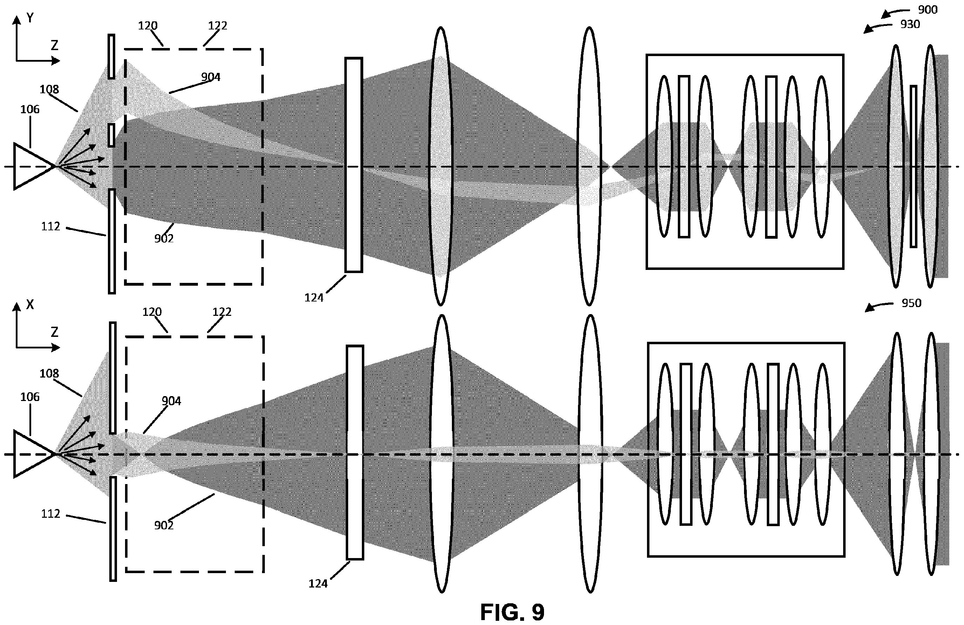

FIG. 1 also shows the bifocal beamformer 112 as applying a distortion to the second charged particle beam 116 that causes the focal properties of the second charged particle beam to differ from the focal properties of the first charged particle beam 114. For example, FIG. 1 illustrates an embodiment of the bifocal beamformer 112 that is configured to generate at least a quadrupole electromagnetic field (i.e. dipole field, quadrupole field, hexapole field, octupole field, etc.) that applies a quadrupole lensing effect to the second charged particle beam 116 such that the two beams have a different focal properties. The at least a quadrupole lensing effect may stigmate, focus, and/or otherwise modify at least one of the beams such that the corresponding focal properties of the beams are made different. In some embodiments, the quadrupole lensing effect may apply a different lensing effects in one meridional plane (e.g. an x-z plane) than in a perpendicular meridional plane (e.g., a y-z plane), causing a different change to each of the focal properties in each of the two meridional planes. Such a stigmation is illustrated in the example system shown in FIG. 9.

In such embodiments, a multipole element (e.g., a stigmator) downstream of the bifocal beamformer may apply a complimentary quadrupole lensing effect to the one of the second charged particle beam 116 to correct for aberrations caused by the bifocal beamformer 112, and cause the second charged particle beam 116 to become a cylindrically symmetric beam again. In this way, the multipole element causes the second electron beam 116 to be cylindrically symmetric downstream of such a multipole element while also having different focal planes from the first charged particle beam 114. In various setups this multipole element may be placed in a focal plane of the first electron beam 114 so that the complementary quadrupole lensing effect is not applied to the first electron beam 114, and/or so that the second electron beam 116 can be made fully cylindrically symmetric.

In some embodiments, the bifocal beamformer 112 is configured to modify the focal properties of at least one of the first charged particle beam 114 and the second charged particle beam 116 such that the second charged particle beam 116 has a focal plane at a specimen plane at or near the sample 104 and the first charged particle beam 114 has a corresponding focal plane that is not at the specimen plane at or near the sample 104. In various embodiments, the bifocal beamformer 112 may modify the focal plane of the first charged particle beam 114 such that it is focused at a plane which is located at least 0.1%, 1%, 10%, or 100 % of the objective lens focal distance above or below the sample 104. Alternatively, the bifocal beamformer 112 may modify the focal properties of at least one of the beams such that the first charged particle beam 114 has a focal plane at a specimen plane at or near the sample 104 and the second charged particle beam 116 has a corresponding focal plane that is not at the specimen plane at or near the sample 104. In such embodiments, the focal plane(s) may be modified such that the second charged particle beam 116 is focused at a plane which is located at least 0.1%, 1%, 10%, or 100 % of the objective lens focal distance above or below the sample 104.

While FIG. 1 illustrates an embodiment where one of the beams is focused in the specimen plane (i.e., have a focal plane at or near the specimen plane), a person having skill in the art will understand that bifocal multibeam charged particle system(s) 100 according to the present invention do not require that either of the charged particle beams be focused in the specimen plane. Moreover, while the bifocal beamformer 112 is shown as modifying the focal properties of the second charged particle beam 116, in other embodiments the bifocal beamformer 112 may cause the focal properties of the first charged particle beam 114, or both beams to be changed, such that the two beams have different corresponding focal planes. That is, a person having skill in the art would understand that the actions or effects described as being applied to one beam may be applied to the other in a different embodiment to enable the two beams to have different corresponding focal planes.

Alternatively or in addition, the bifocal beamformer 112 may be configured to modify the focal properties of at least one of the first charged particle beam 114 and the second charged particle beam 116 such that the diameter of the first charged particle beam 114 at a specimen plane at or near the sample 104 is at least one of 50, 100, 500, or 1000 times greater than the diameter of the second charged particle beam 116 at the specimen plane. In such embodiments, the bifocal beamformer 112 may cause the diameter of the first charged particle beam 114 to be at least one of 5, 10, 20, 50, 100, 500, or 1000 times greater than the diameter for the second charged particle beam 116 at or proximate to each crossover point of the second charged particle beam 116. In some embodiments, the bifocal beamformer 112 further causes one or both of the first charged particle beam 114 and the second charged particle beam 116 to be deflected away from the emission axis 110.

In some embodiments, the bifocal beamformer 112 may be composed of a single component that performs both the forming of the first charged particle 114 beam and the second charged particle beam 116 and the modification of the focal properties of at least one of the two beams. For example, the bifocal beamformer 112 may correspond to a microelectromechanical system (MEMS) that both forms the two beams and generates at least a quadrupole electromagnetic field which applies at least a quadrupole lensing effect (i.e. dipole field, quadrupole field, hexapole field, octupole field, etc.) which applies at least a quadrupole lensing effect that focuses, stigmates, and/or otherwise modifies at least one of the beams such that the corresponding focal properties of the beams are made different. In another example, the bifocal beamformer 112 may correspond to an aperture array comprising a structure defining a plurality of apertures and/or cavities that both form the two beams and create at least a quadrupole electromagnetic field that applies the quadrupole lensing effect to one or more of the two beams. In some embodiments, the quadrupole lensing effect may apply a positive lensing in one meridional plane (e.g. an x-z plane) and a negative lensing effect in a perpendicular meridional plane (e.g., a y-z plane), causing a different change to each of the focal properties in each of the two meridional planes.

In such systems, a multipole element 124 (e.g., a stigmator or a multipole element which is part of an aberration corrector, a corrector of the quadrupole/octupole type, etc.) may be included in the example bifocal multibeam charged particle system(s) 100 further downstream to apply a complementary quadrupole lensing effect to make the beam cylindrically symmetric again. For example, FIG. 1 illustrates the bifocal multibeam system(s) 102 as including a stigmator. Such a system component may be positioned in a focal plane of a charged particle beam to which bifocal beamformer 112 did not apply at least a quadrupole lensing effect. In embodiments where the bifocal beamformer applies at least a first quadrupole lensing effect to the first charged particle beam 114 and a second quadrupole lensing effect to the second charged particle beam 116, such a bifocal charged particle multibeam system(s) 100 may include a first multipole element 124 positioned in a focal plane of the first charged particle beam 114 and configured to apply a complementary quadrupole lensing effect to the second charged particle beam 116, and a second multipole element 124 positioned in a focal plane of the second charged particle beam 116 and configured to apply a complementary quadrupole lensing effect to the first charged particle beam 114.

Alternatively, the bifocal beamformer 112 may be composed of a plurality of components 118. Individual components 118 may perform one of the forming of the first charged particle 114 beam and the second charged particle beam 116 and the modification of the focal properties of at least one of the two beams, or they may contribute to one or both of the forming the beams and modifying of focal properties in concert with other components 118. In some embodiments, the individual components 118 may include a physical structure that blocks a portion of the plurality of charged particles 108 while allowing others to pass through, a biprism (e.g., a charged wire), an amplitude-division electron beam splitter made of thin crystals or nanofabricated gratings, a beam splitting laser system configured to use one or more lasers pattern fringes to split the plurality of charged particles 108 into the first charged particle 114 beam and the second charged particle beam 116, etc. Alternatively, or in addition, the individual components 118 may include one or more lenses (e.g., an einzel lens, a quadrupole lens, etc.) that are positioned or otherwise configured to cause the first charged particle beam 114 and the second charged particle beam 116 to have different focal properties. For example, the bifocal beamformer 112 may be composed of a physical structure defining two apertures, and a lens positioned and/or configured to adjust the focal properties of the at least one of the first charged particle beam and the second charged particle beam such that they have different corresponding focal planes. In such an example, wherein the portion of the plurality of charged particles 108 that pass through the first aperture become the first charged particle beam 114, and the portion of the plurality of charged particles 108 that pass through the second aperture become the second charged particle beam 116. In various embodiments, such a lens may be positioned above or below the physical structure.

FIG. 1 illustrates the bifocal beamformer 112 as being positioned upstream of focusing component 120 that is configured to apply a lensing action that focuses at least one of the first charged particle beam 114 and the second charged particle beam 116. Moreover, the focusing component 120 is positioned upstream of the multipole element 124. In the example bifocal multibeam charged particle system(s) 102 shown in FIG.1, the focusing component corresponds to an accelerator 122 that accelerates/decelerates, focuses, and/or directs the first charged particle beam 114 and the second charged particle beam 116 towards a focusing column 126. However, in other embodiments, the accelerator 122 may be positioned between charged particle source 106 and the bifocal beamformer 112 such that the accelerator 122 accelerates/decelerates, focuses, and/or directs the charged particles 108 to the bifocal beamformer 112, and the bifocal beamformer 112 splits and modifies the focal properties of charged particles 108 at a final energy (e.g., 30 kV). In such embodiments, the focusing component 120 may correspond to a lens or other structure configured to apply a lens action that focuses at least one of the first charged particle beam 114 and the second charged particle beam 116.

The focusing column 126 focuses the charged particle beams 114 and 116 so that they are incident on sample 104. Specifically, FIG. 1 illustrates the focusing column 126 focusing the second charged particle beam 116 so that is focused on the sample 104 and the first charged particle beam 114 such that it is not focused on the sample 104. In some embodiments, one of the first charged particle beam 114 or second charged particle beam 116 may be parallel and/or substantially parallel when it is incident on the sample 104. Moreover, in other embodiments, the focusing column 126 may cause the first charged particle beam 114 to be focused on the sample 104 and the second charged particle beam 116 to not be focused on the sample 104. While not illustrated in FIG. 1, those having skill in the art will understand focusing column 126 may include one or more correctors (e.g., a Cs or Cs+Cc aberration corrector), transfer lenses, deflectors, scan coils, beam blankers, etc. necessary to enable and/or enhance the investigation of the sample 104 with the bifocal multibeam charged particle system(s) 100.

FIG. 1 also shows the bifocal multibeam charged particle system(s) 100 as including an objective lens 128. The objective lens 128 is an optical element that focuses one of the first charged particle beam 114 and the second charged particle beam 116 to a point on the sample 104. The objective lens 128 may comprise a single-polepiece lens, a magnetic electrostatic compound lens, electrostatic detector objective lens, or another type of objective lens. For example, the objective lens 128 may correspond to a TEM objective lens in which the sample is immersed within the TEM objective lens and/or between the pre-specimen and post specimen components of the TEM objective lens. As will be understood by people having skill in the art, in other embodiments the focusing column 126 may include other components (e.g., lenses, deflectors, scan coils, correctors, beam blankers, beam stops, etc.) necessary to enable and/or enhance the investigation of the sample 104 with the bifocal multibeam charged particle system(s) 100.

FIG. 1 further illustrates the example bifocal multibeam charged particle system(s) 100 as including a sample holder 130 that holds the sample 104. Where the example bifocal multibeam charged particle system(s) 102 is a TEM or STEM system, such an embodiment may include a detector 132 that is configured to detect charged particles 134 that pass through the sample 104 as a result of the charged particle beams 114 and 116 being incident on the sample 104. Such an embodiment may further include one or more projection lenses 136 positioned between the sample 104 and the detector 132. Alternatively or in addition, where the example bifocal multibeam charged particle system(s) 102 is a SEM or STEM, such embodiments may include one or more additional detectors 140.

FIG. 1 further shows bifocal multibeam charged particle system(s) 100 as optionally including a computing device(s) 142. Those skilled in the art will appreciate that the computing devices 142 depicted in FIG. 1 are merely illustrative and are not intended to limit the scope of the present disclosure. The computing system and devices may include any combination of hardware or software that can perform the indicated functions, including computers, network devices, internet appliances, PDAs, wireless phones, controllers, oscilloscopes, amplifiers, etc. The computing devices 142 may also be connected to other devices that are not illustrated, or instead may operate as a stand-alone system.

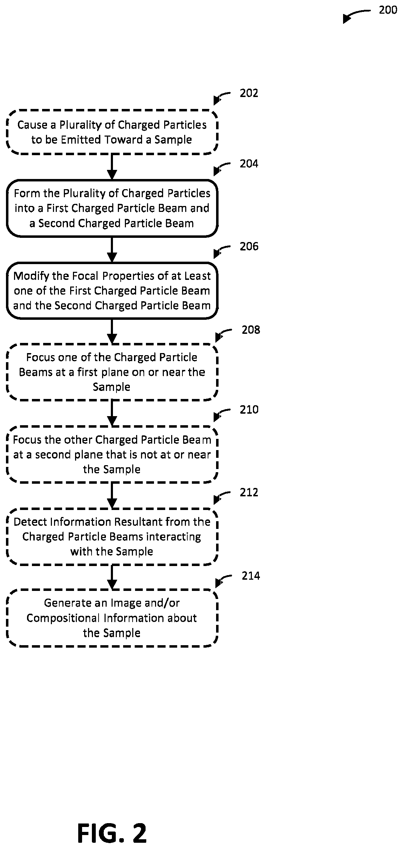

FIG. 2 is a flow diagram of illustrative processes illustrated as a collection of blocks in a logical flow graph, which represent a sequence of operations that can be implemented in hardware, software, human operation, or a combination thereof. In the context of software, the blocks represent computer-executable instructions stored on one or more computer-readable storage media that, when executed by one or more processors, cause the performance of the recited operations. Generally, computer-executable instructions include routines, programs, objects, components, data structures, and the like that perform particular functions or implement particular abstract data types. The order in which the operations are described is not intended to be construed as a limitation, and any number of the described blocks can be combined in any order and/or in parallel to implement the processes.

FIG. 2 is a depiction of a sample process 200 for investigation of a sample with a bifocal multibeam charged particle system(s) 100 according to the present invention. The process 200 may be implemented in any of the example charged particle microscope system(s) 102, 300, 1000, and 2000.

At 202, a plurality of charged particles are emitted towards a sample by a charged particle source. The charged particle source may include a thermal electron source, Schottky-emission source, field emission source, a liquid metal ion source, a plasma ion source, etc. For example, in some embodiments, the charged particle source is an electron source that emits a plurality of electrons toward the sample.

At 204, the plurality of charged particles are formed into a first charged particle beam and a second charged particle beam. According to the present invention, the plurality of charged particles are formed into the two beams by a bifocal beamformer or a component thereof. In some embodiments, a component of the bifocal beamformer defines at least a first aperture that is configured to allow a first portion of the charged particles to pass through the bifocal beamformer (i.e., the first charged particle beam) and a second aperture configured to allow a second portion of the charged particles to pass through the bifocal beamformer (i.e., the second charged particle beam). Alternatively, or in addition, the bifocal beamformer may include a biprism, an amplitude-division electron beam splitter made of thin crystals or nanofabricated gratings, a beam splitting laser system, or another type of mechanism known to those skilled in the art for splitting charged particle beams.

At 206, the focal properties of at least one of the first charged particle beam and the second charged particle beam is modified. Specifically, according to the present invention the bifocal beamformer or a component thereof is further configured to modify the focal properties of at least one of the first charged particle beam and a second charged particle beam such that the two beams have different corresponding focal planes. In some embodiments, the focal properties and/or focal planes of both beams is adjusted. However, in other embodiments, the focal properties and/or focal planes of just one of the two beams is adjusted.

In some embodiments, the bifocal beamformer is a MEMS device that comprises a plurality of electrodes configured to, when certain voltages are applied thereto, generate an electromagnetic field pattern that applies at least a lensing effect (e.g., a quadrupole lensing effect and/or a round lens effect) to one of the charged particle beams. In another example, where the bifocal beamformer comprises a plurality of holes and/or cavities, the plurality of apertures holes and/or cavities form a pattern that creates an electromagnetic field (e.g., a quadrupole electromagnetic field) that applies at least a lensing effect (e.g., a quadrupole lensing effect) to the second charged particle beam during use of the bifocal beamformer. Such lensing effects focus, stigmate and/or otherwise modify at least the charged particle beam such that the corresponding focal properties of the two beams are made different. Alternatively, or in addition, the bifocal beamformer may include one or more lenses positioned or otherwise configured to modify the focal planes of the first or second charged particle beam. In some embodiments, the bifocal beamformer adjusts the focal properties and/or focal planes of different regions of the charged particles emitted by the charged particle source before they are split into the first and second charged particle beams, such that when the charged particles are split into the two charged particle beams, the two beams have different corresponding focal planes.

At 208, one of the charged particle beams is focused onto a first plane on the sample, and at 210, the other charged particle beam is focused on a second plane that is not at or near the sample. In some embodiments, the other charged particle beam is focused on a plane located at least 0.1%, 1%, 10%, or 100 % of the objective lens focal distance above or below the sample. Additionally, the two charged particle beams may be focused such that the diameter of one of the charged particle beams at the sample is at least one of 50, 100, 500, or 1000 times greater than the diameter of the other charged particle beam at the sample. In some embodiments, the charged particle beams pass through a focusing column that directs them onto their respective focus planes. The focusing column may include one or more correctors, transfer lenses, deflectors, scan coils, beam blankers, etc. necessary to enable and/or enhance the investigation of the sample.

At 212, charged particles and/or emissions resultant from the charged particle beams interacting with the sample are detected. For example, one or more detectors positioned above or below the sample may detect portions of the charged particle beams that are transmitted through the sample, charged particles reflected by the sample, emissions from the sample, or a combination thereof.

At 214, an image is generated and/or compositional information about the sample is determined based on the events detected by the one or more detectors. For example, a camera or other type of detector may be used to receive a portion of the charged particle beam that is transmitted through the sample and/or charged particles reflected/emitted by the sample, and a computing device associated with the charged particle system may generate an image (e.g., sample image, diffraction pattern, etc.) based on the data from the camera and/or sensor.

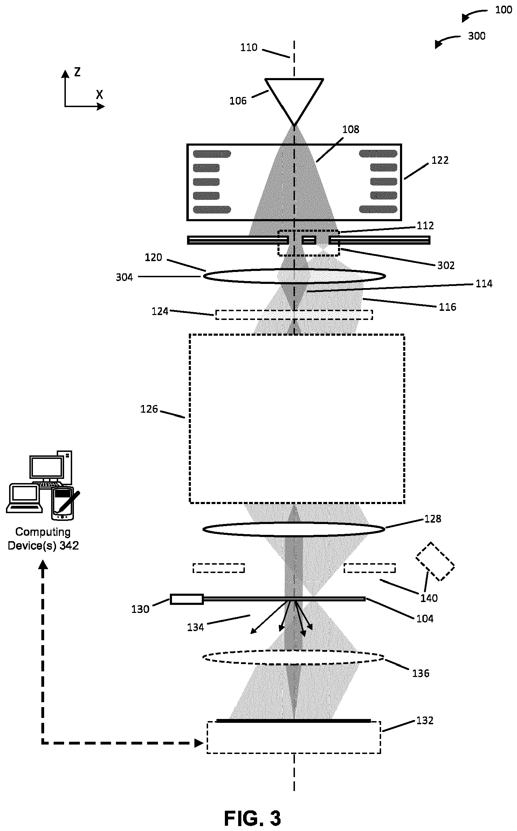

FIG. 3 is an illustration of an example embodiment 300 of bifocal multibeam charged particle system(s) 100 for investigating a sample 104 where the bifocal beamformer comprises a MEMS device.

The example bifocal multibeam charged particle system(s) 300 includes a charged particle source 106 that emits a plurality of charged particles 108 along an emission axis 110 and towards an accelerator 120. The accelerator 120 accelerates/decelerates, focuses, and/or directs the first charged particle beam 114 and the second charged particle beam 116 towards a bifocal beamformer 112. FIG. 3 illustrates the accelerator 120 as being positioned upstream of bifocal beamformer 112, as discussed above, in other embodiments the bifocal beamformer 112 may be positioned between charged particle source 106 and the accelerator 120.

In example bifocal multibeam charged particle system(s) 300, the bifocal beamformer 112 corresponds to a MEMS device 302. The MEMS device 302 defines a first aperture and a second aperture that are each configured to allow a portion of the plurality of charged particles 108 to pass through the MEMS device 302. In this way, the first aperture and the second aperture split the plurality of charged particles 108 into the first charged particle beam 114 and the second charged particle beam 116, respectively. FIG. 3 illustrates the first charged particle beam 114 as being an axial beam.

The MEMS device 302 further comprises a plurality of electrodes that are configured such that, when certain voltages are applied thereto, the electrodes generate a quadrupole electromagnetic field pattern that applies at least a quadrupole lensing effect (i.e., dipole field, quadrupole field, hexapole field, octupole field, etc.) to the second charged particle beam 116. The quadrupole lensing effect focuses, stigmates, and/or otherwise modifies at least the second charged particle beam 116 such that the corresponding focal properties of the beams are made different. In some embodiments, the electrodes are configured such that the first charged particle beam 114 is not affected by the electromagnetic field generated by the electrodes and/or such an effect is reduced. Alternatively, or in addition, a portion of the electrodes may generate an electromagnetic field that applies a different lensing effect to the first charged particle beam 114 and the second charged particle beam 116.

FIG. 3 illustrates the MEMS device 302 as being positioned upstream of focusing component 120 that is configured to apply a lensing action that focuses at least one of the first charged particle beam 114 and the second charged particle beam 116. In the example bifocal multibeam charged particle system(s) 200 shown in FIG. 3, the focusing component corresponds to lens 120 that focuses, and/or directs the first charged particle beam 114 and the second charged particle beam 116 towards a focusing column 126. However, in other embodiments the accelerator 122 may be positioned between charged particle source 106 and the MEMS device 302, and the accelerator 122 may replace or augment the lens 304 (as illustrated in FIG. 1).

The focusing column 126 and the objective lens 128 focus the charged particle beams 114 and 116 so that they are incident on sample 104. Specifically, FIG. 3 illustrates the focusing column 126 focusing the second charged particle beam 116 so that is focused on the sample 104 and the first charged particle beam 114 such that it is not focused on the sample 104. In some embodiments, the focal planes the first charged particle beam 114 and the second charged particle beam 116 are modified such that one of the beams is focused at a plane at or near the sample 104 and the other charged particle beam is focused at a plane which is located at least 0.1%, 1%, 10%, or 100 % of the objective lens focal distance above or below the sample 104. Alternatively or in addition, the focal planes of the first charged particle beam 114 and the second charged particle beam 116 may be modified such that the diameter of one of the charged particle beams at the sample 104 is at least one of 50, 100, 500, or 1000 times greater than the diameter of the other charged particle beam at the sample.

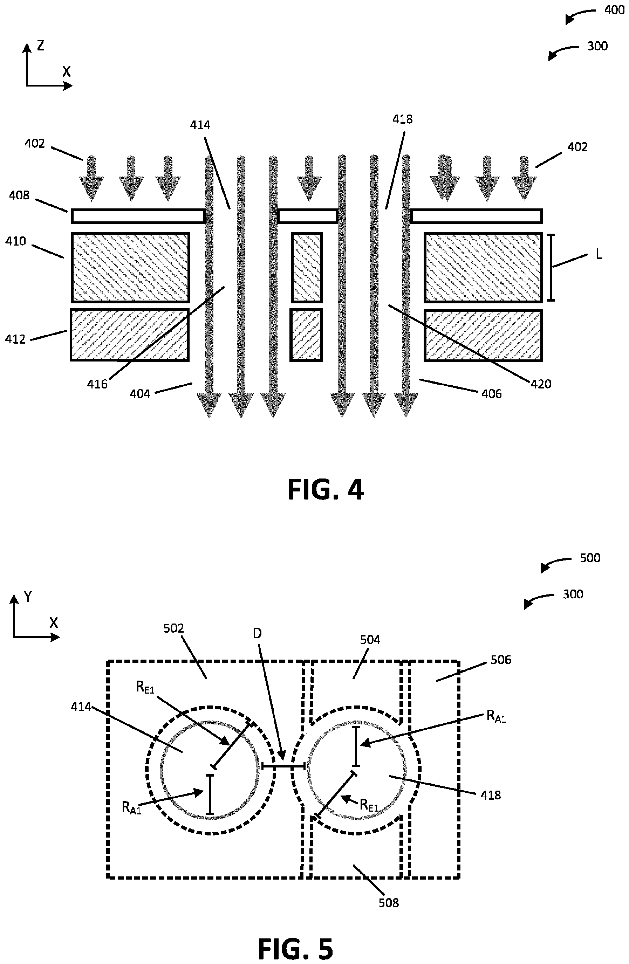

FIG. 4 shows a cross section of an example embodiment 400 of MEMS device 300 according to the present invention. Specifically, FIG. 4 illustrates a cross section of a MEMS device 300 configured to split a plurality of charged particles 402 into the first charged particle beam 404 and the second charged particle beam 406, and generate an electromagnetic field pattern that applies at least a quadrupole lensing effect to the second charged particle beam 406. The at least the quadrupole lensing effect causes the first charged particle beam 404 and the second charged particle beam 406 to have different focal properties. For example, the quadrupole lensing effect may apply a positive lensing effect in one meridional plane (e.g. an y-z plane) and a negative lensing effect in a perpendicular meridional plane (e.g., a x-z plane), causing a different change to the focal properties in each of the two meridional planes. In such embodiments, another system component (e.g., a stigmator) may be included downstream of the bifocal beamformer 300 to apply another quadrupole lensing effect to make the beam cylindrically symmetric again.

FIG. 4 illustrates MEMS device 300 as including a surface layer 408, an electrode layer 410, and an optional shielding layer 412. In FIG. 4, the surface layer 408 is shown as comprising a thin material (e.g., a foil) upon which the charged particles 402 are incident. However, a person having skill in the art would understand that in other embodiments, the surface layer 408 may not be a correspond to separate component layer, but rather correspond to an upper surface of one or more components of the MEMS device 300 upon which the charged particles 402 are incident.

The surface layer 408 defines a first entrance 414 to a first aperture 416 and a second entrance 418 to a second aperture 420. In some embodiments, the first aperture 414 is an axial aperture (i.e., positioned on the emission axis of the charged particles 402) and the second aperture 418 is a non-axial aperture. In such embodiments, the first charged particle beam 404 is an axial beam. The first entrance 414 allows a first portion of the charged particles 402 (i.e., the first charged particle beam 404) to pass into the first aperture 416 and through the MEMS device 300. Similarly, the second entrance 418 allows a second portion of the charged particles 402 (i.e., the second charged particle beam 406) to pass into the second aperture 420 and through the MEMS device 300. The surface layer 408 inhibits the ability of the remaining portions of charged particles 402 to pass into and/or through the MEMS device 300.

The electrode layer 410 comprises a plurality of micro-electrodes that are shaped, positioned, or otherwise configured such that when corresponding voltages are applied to the one or more electrodes, the one or more electrode generate electromagnetic field patterns that apply a lensing effect to one or both of the first charged particle beam 404 and the second charged particle beam 406. The lensing effect is such that the focal properties of the two beams are modified such that they have different corresponding focal properties. One or more of the magnitude of the voltages applied to the electrodes, the shape of the electrodes, and the thickness (L) of the electrodes can be modified to change the strength of the generated electromagnetic field patterns. According to the present invention, the electrodes in the electrode layer 410 are configured such that they generate at least a quadrupole electromagnetic field pattern applies at least a quadrupole lensing effect to the second charged particle beam 406. In some embodiments, the electromagnetic field pattern may also apply dipole fields to one or both of the first charged particle beam 404 and the second charged particle beam 406. Such dipole fields may cause at least one of the charged particle beams to be deflected in a direction perpendicular to the emission axis.

FIG. 4 also illustrates the MEMS device 300 as including an optional shielding layer 412 that is opposite the surface layer 408, and which is configured to at least partially shield the first charged particle beam 414 from the at least quadrupole lensing effects applied to the second charged particle beam 416.

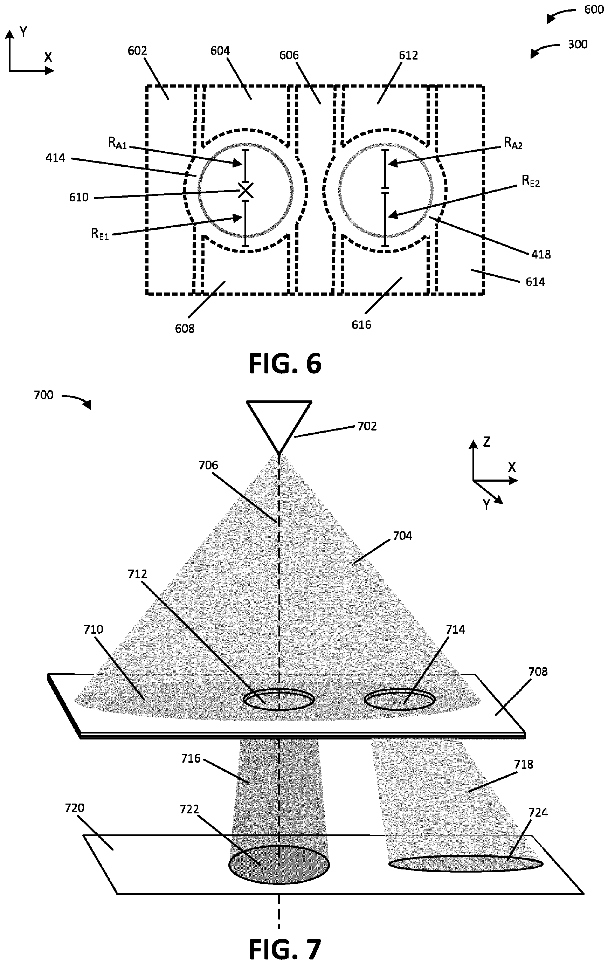

FIG. 5 shows top down schematic view of an example embodiment 500 of MEMS device 300 that comprises four electrodes. FIGS. 5 and 6 illustrate in solid lines the first entrance 414 and second entrance 418 as defined by surface layer 408 in solid lines. Additionally, FIGS. 5 and 6 illustrate the components of the electrode layer 410 in dashed lines. A person having skill in the art would recognize that the dashed lines do not represent the exact shape, but rather indicate general outlines electrodes in the electrode layer 410.

FIG. 5 shows the radius $R_{A1}$ of the first entrance 414 as being lesser than the radius $R_{E1}$ of the first aperture 416 as at least partially defined by electrode 502. In an embodiment of example MEMS device 500, the radius $R_{A1}$ may be at or around 10$\mu$m and the radius $R_{E1}$ may be at or around 14$\mu$m or greater. The radius $R_{A2}$ of the second entrance 418 is shown in FIG. 5 as being lesser than the radius $R_{E2}$ of the second aperture 420 as at least partially defined by electrodes 502, 504, 506, and 508. However, in other embodiments one or both of radius $R_{E1}$ and radius $R_{A1}$ and/or radius $R_{E2}$ and radius $R_{A2}$ may be the same. The example embodiment 500 is further shown as having the radius $R_{A1}$ and the radius $R_{A2}$ as being equal and/or approximately equal, however this is not required for all embodiments. The first entrance 414 and the second entrance 418 are separated by the distance D.

During use of the example MEMS device 500, voltages may be applied to one or more of the electrodes 502-508 such that the electrodes generate an electromagnetic field that applies at least a quadrupole lensing effect to the second charged particle beam 406. In some embodiments, one or more of the electrodes may be grounded. For example, the example MEMS device 500 may generate an electromagnetic field that applies at least a quadrupole lensing effect to the second charged particle beam 406 when a first voltage VI is applied the electrode 504, a second voltage V2 is applied to electrode 508, and electrodes 502 and 506 are grounded. In various embodiments, V1 and V2 may each be greater than - 20V and less than 20V, however larger voltages can also be used.

FIG. 6 shows top down schematic view of an example embodiment 600 of MEMS device 300 that comprises seven electrodes. FIG. 6 shows the radius $R_{A1}$ of the first entrance 414 as being lesser than the radius $R_{E1}$ of the first aperture 416 as at least partially defined by electrodes 602, 604, 606, and 608. FIG. 6 illustrates the first aperture 414 as being an axial aperture through which the emission axis 610 of the plurality of charged particles 402 passes.

The radius $R_{A2}$ of the second entrance 418 is also shown in FIG. 6 as being lesser than the radius $R_{E2}$ of the second aperture 420 as at least partially defined by electrodes 606, 612, 614, and 616. However, in other embodiments one or both of radius $R_{E1}$ and radius $R_{A1}$ and/or radius $R_{E2}$ and radius $R_{A2}$ may be the same.

During use of the example MEMS device 600, voltages may be applied to one or more of the electrodes 602-608 and 612-616 such that the electrodes generate an electromagnetic field that applies at least a quadrupole lensing effect to the second charged particle beam 406. In some embodiments, one or more of the electrodes may be grounded. For example, the example MEMS device 600 may generate an electromagnetic field that applies at least a quadrupole lensing effect to the second charged particle beam 406 when a first set of voltages between the values of -20V and 20V are applied to electrodes 604, 608, 612, and 616, a second set of voltages between the values of -5V and 5V is applied to electrodes 602 and 614, and electrode 606 is grounded.

Additionally, a person having skill in the art would understand that the dashed lines in FIGS. 5 and 6 represent example configurations of electrodes, and that experimentation would provide multiple electrode configurations (e.g., electrode size, electrode shape, quantity of electrodes, layout of electrodes, combination of voltages applied to electrodes, etc.) that cause the electrodes to generate an electromagnetic field that applies at least a quadrupole lensing effect to the second charged particle beam 406. Moreover, while each of FIGS. 5 and 6 illustrate an embodiment where the at least quadrupole lensing effect is applied to the second charged particle beam 406, in other embodiments the electrode layer 410 may be configured to generate an electromagnetic field that applies at least a quadrupole lensing effect to the first charged particle beam 404 (or both charged particle beams) when a corresponding set of voltages are applied to the electrodes.

FIG. 7 is an illustration 700 of the change in focal properties of the second charged particle beam caused when an example embodiment bifocal beamformer causes at least a quadrupole lensing effect to be applied thereto. Specifically, FIG. 7 shows an emitter 702 emitting a plurality of charged particles 704 along an emission axis 706. The plurality of charged particles 704 strike the bifocal beamformer 708 in a circular area 710. The bifocal beamformer 708 is shown in FIG. 7 as being a MEMS device that (i) defines a first aperture 712 and a second aperture 714 that split the charged particle beam 704 into a first charged particle beam 716 and a second charged particle beam 718, respectively, and (ii) generates an electromagnetic field that applies at least a quadrupole lensing effect to the second charged particle beam 718 when in use.

As illustrated in FIG. 7, in some embodiments the at least a quadrupole lensing effect causes the second charged particle beam 718 to be distorted such that it (i) has a different focal properties from the first charged particle beam 716, and (ii) is no longer a cylindrically symmetric beam. Specifically, FIG. 7 shows the cross-sectional areas of the first charged particle beam 716 and the second charged particle beam 718 in a plane 720 downstream of the bifocal beamformer 708, where the emission axis is normal to the plane 720. The first charged particle beam 716 is shown as having a circular (or near circular) cross section 722 when it crosses the plane 720, and the second charged particle beam 718 is shown as having a non-circular cross section 724 when it crosses the plane 720. Applicant notes that these cross sections are not illustrative of the performance of all embodiments of bifocal beamformers according to the present invention, but are limited to the specific example embodiment of bifocal beamformer 708.

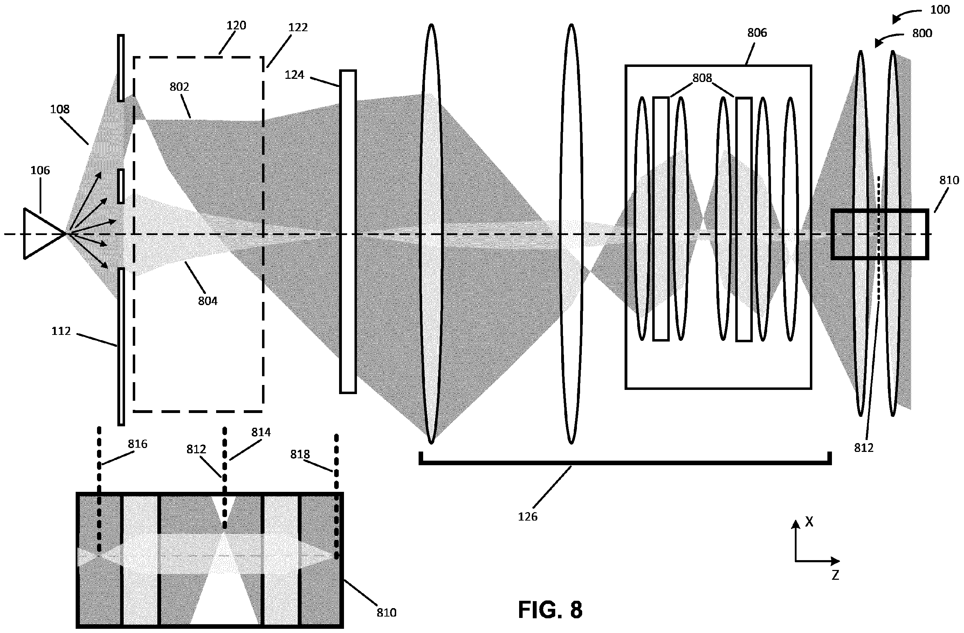

FIGS. 8 and 9 are illustrations of the optical performance of a bifocal multibeam charged particle system(s) 100 according to the present invention. Specifically, FIG. 8 shows example beam paths of bifocal multibeam charged particle system 800 where at least a quadrupole lensing effect is applied to a non-axial reference charged particle beam 802 and an axial charged particle TEM beam 804.

FIG. 8 depicts a charged particle source 106 (e.g., an electron source) emitting a plurality of charged particles 108 (e.g., electrons) toward a bifocal beamformer 112. The bifocal beamformer 112 is illustrated as both splitting the plurality of charged particles 108 into a non-axial reference charged particle beam 802 and an axial charged particle TEM beam 804. FIG. 8 further illustrates the bifocal beamformer 112 as applying at least a quadrupole lensing effect to the non-axial reference charged particle beam 802, which changes the focal properties of the non-axial reference charged particle beam 802.

A result of the quadrupole lensing effect is that the non-axial reference charged particle beam 802 is no longer a cylindrically symmetric beam. A multipole element 124 (e.g. a stigmator) for correcting one or more astigmatisms and/or causing the non-axial reference charged particle beam 802 to be cylindrically symmetric is shown in FIG. 1 as being positioned at a focal plane of the axial charged particle TEM beam 804. For example, the multipole element 124 may apply at least a quadrupole lensing effect to the non-axial reference charged particle beam 802 such that it becomes cylindrically symmetric again. Because the multipole element is positioned in a plane where the axial reference charged particle beam 802 is focused to a point, the effect of this element on the beam is minimized.

The focusing column 126 is shown as including a hexapole corrector 806. In the depicted embodiment, the hexapoles 808 of the hexapole corrector 806 are shown as being positioned at focal planes of the axial charged particle TEM beam 804. The focusing column 126 is shown as focusing the non-axial reference charged particle beam 802 onto a specimen focal plane 812. To illustrate this, FIG. 8 depicts an inset 810 that shows a focal plane 814 of the on-axial reference charged particle beam 802 as coinciding with the specimen focal plane 812. The inset 810 further shows that the focusing column 126 as focusing the axial charged particle TEM beam 804 such that it has a focal plane 816 upstream of the specimen focal plane 812 and a focal plane 818 downstream of the specimen focal plane 814.

FIG. 9 shows example beam paths of example bifocal multibeam charged particle system 900 where a quadrupole lensing effect is applied to an axial first charged particle beam 902, and no quadrupole lensing effect is applied to a non-axial second charged particle beam 904. Specifically, FIG. 9 shows example beam paths of the axial first charged particle beam 902 and the non-axial second charged particle beam 904 in the y-z plane 930, and the x-z plane 950, respectively.

FIG. 9 depicts a charged particle source 106 emitting a plurality of charged particles 108 toward a bifocal beamformer 112. The bifocal beamformer 112 is illustrated as both splitting the plurality of charged particles 108 into an axial first charged particle beam 902 and a non-axial second charged particle beam 904. FIG. 9 further illustrates the bifocal beamformer 112 as applying at least a quadrupole lensing effect to the axial first charged particle beam 902, which changes the focal properties of the axial first charged particle beam 902. Specifically, FIG. 9 collectively shows how in some embodiments the at least the quadrupole lensing effect applies a stigmation to the first charged particle beam. That is, FIG.9 illustrates how the quadrupole lensing effect may apply a first lensing effect to the axial first charged particle beam 902 in one meridional plane (i.e., a negative lensing effect in the x-z plane) and a second, different lensing effect to the axial first charged particle beam 902 in a perpendicular meridional plane (i.e., a positive lensing effect in the y-z plane). FIG. 9 shows how these two different lensing effects in different planes cause the first charged particle beam 902 to no longer be a cylindrically symmetric beam (i.e., the radius of the beam in the x-z plane is not same as the radius of the beam in the y-z plane) between the bifocal beamformer 112 and the multipole element 124.

FIG. 9 also illustrates the example bifocal multibeam charged particle system 900 as including a multipole element 124 that is positioned at a focal plane of the non-axial second charged particle beam 904. This is also the plane where the beam shape is circular (i.e. equal radii in xz- and yz-plane), which means that an appropriate quadrupole lensing effect by element 124 can equalize beam envelope angles in the xz- and yz-plane, thus making the beam fully cylindrically symmetric. Because the multipole element 124 is positioned in a plane where the non-axial second charged particle beam 904 is focused to a point, the effect of the corrector on the non-axial second charged particle beam 904 is minimized. In various embodiments, the column deflectors and/or the tilt of sample holder can be used to tune the tilt and/or shift of the charged particle beams with respect to sample, while preserving the mutual tilt angle between the two beams.

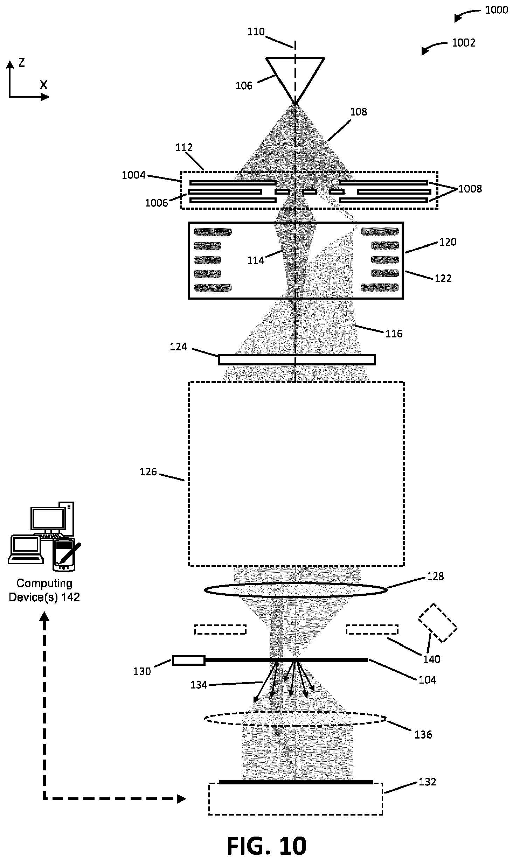

FIG. 10 is an illustration of an example embodiment 300 of bifocal multibeam charged particle system(s) 100 for investigating a sample 104 where the bifocal beamformer comprises an aperture lens array 1004.

The example bifocal multibeam charged particle system(s) 1002 includes a charged particle source 106 that emits a plurality of charged particles 108 along an emission axis 110 and towards an aperture lens array 1004. The aperture lens array 1004 comprises at least one aperture defining structure 1006 that defines (i) a first aperture that allows the first charged particle beam 114 to pass through the at least one aperture defining structure 1006, (ii) a second aperture that allows the second charged particle beam 116 to pass through the at least one aperture defining structure 1006, and (iii) plurality of other apertures. The first aperture, the second aperture, and the plurality of apertures collectively form a pattern that, when a voltage(s) is applied to the aperture defining structure 1006 and the electrode(s) 1008, creates an electromagnetic field that applies a lensing effect (e.g., at least a quadrupole lensing effect) to at least one of the first charged particle beam 114 and the second charged particle beam 116. The lensing effect distorts one or both of the first charged particle beam 114 and the second charged particle beam 116 such that they have different focal properties. In some embodiments, the electromagnetic field created by the aperture lens array 1004 further causes one or both of the first charged particle beam 114 and the second charged particle beam 116 to be deflected away from the emission axis 110.

The aperture lens array 1004 further comprises one or more electrodes (e.g., disk electrodes) 1008. The each of the one or more electrodes 1008 generate an electric field between the corresponding electrode and the at least one aperture defining structure 1006 when a voltage is supplied thereto. Additionally, in some embodiments, one or more of the electrodes 1008 may physically block a portion of the plurality of charged particles 108 from reaching the at least one aperture defining structure 106. For example, one of the electrodes 1008 may define a first aperture that allows a first portion of charged particles to pass through the electrode (i.e., a first charged particle beam) and a second aperture that allows a second portion of charged particles to pass through the electrode (i.e., a second charged particle beam).

FIG. 10 illustrates the bifocal beamformer 112 as being positioned upstream of focusing component 120 that is configured to apply a lensing action that focuses at least one of the first charged particle beam 114 and the second charged particle beam 116. In the example bifocal multibeam charged particle system(s) 1002 shown in FIG.10, the focusing component corresponds to an accelerator 122 that accelerates/decelerates, focuses, and/or directs the first charged particle beam 114 and the second charged particle beam 116 towards a focusing column 126.

The focusing column 126 and the objective lens 128 focus the charged particle beams 114 and 116 so that they are incident on sample 104. Specifically, FIG. 10 illustrates the focusing column 126 focusing the second charged particle beam 116 so that is focused on a plane at or near the sample 104 and the first charged particle beam 114 such that it is not focused at the plane at or near the sample 104. In some embodiments, the focal properties of the first charged particle beam 114 and the second charged particle beam 116 are modified such that one of the beams is focused at a plane at or near the sample 104 and the other charged particle beam is focused at a plane which is located at least 0.1%, 1%, 10%, or 100 % of the objective lens focal distance above or below the sample 104. Alternatively or in addition, the focal properties the first charged particle beam 114 and the second charged particle beam 116 may be modified such that the diameter of one of the charged particle beams at the sample 104 is at least one of 50, 100, 500, or 1000 times greater than the diameter of the other charged particle beam at the sample.

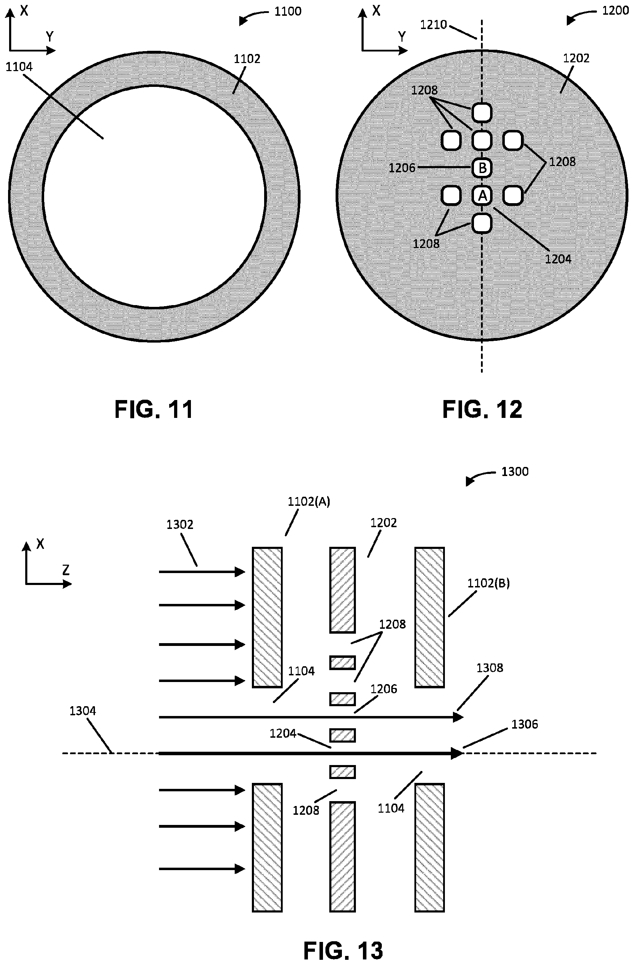

FIG. 11 illustrates an example 1000 electrode 1102 for an example aperture lens array 1004. The electrode 1008 is shown in FIG. 11 as being a disk electrode 1102 that defines an aperture 1104 that allows charged particles to pass through the disk electrode 1102.

FIG. 12 illustrates an example 1200 aperture defining structure 1202 for an example aperture lens array 1004. The example aperture defining structure 1202 defines (i) a first aperture 1204 that allows a first charged particle beam to pass through the at least one aperture defining structure 1202, (ii) a second aperture 1206 that allows a second charged particle beam to pass through the at least one aperture defining structure 1202, and (iii) plurality of other apertures 1208. In the example embodiment shown in FIG 12, each of the first aperture 1204, the second aperture 1206, and three apertures 1208 are positioned along a midline 1210 of the aperture defining structure 1202.

FIG. 12 illustrates each of the plurality of other apertures 1208 as being holes that allow charged particles to pass through the aperture defining structure 1202. However, in other embodiments one or more of the apertures 128 may be cavities where the aperture defining structure 1202 defines an empty space into which charged particles are allowed to enter, but which do not allow the charged particles to pass through the aperture defining structure. The first aperture 1204, the second aperture 1206, and the plurality of apertures 1208 collectively form a pattern that induces an electromagnetic field that applies a lensing effect (e.g., at least a quadrupole lensing effect) to at least the second charged particle beam.

FIG. 13 illustrates a cross section of an example aperture lens array 1300 having one aperture defining structure. Specifically, FIG. 13 shows a cross section of an example aperture lens array 1300 comprising the example electrode 1102 of FIG. 11 and the example aperture structure 1202 of FIG. 12, where the cut of the cross section aligns with the midline 1210 of the example aperture structure 1202.

FIG. 13 shows charged particles 1302 being emitted along an emission axis toward the electrode 1102. A portion of the charged particles 1302 pass through both the aperture 1104 and the first aperture 1204, becoming first charged particle beam 1306. Another portion of the charged particles 1302 pass through both the aperture 1104 and the second aperture 1206, becoming second charged particle beam 1308. In some embodiments, the aperture lens array 1300 includes a second electrode positioned such that the at least one aperture defining structure 1202 is between the two electrodes. When voltages are applied to the electrode 1102(A), the electrode 1102(B), both electrodes 1102(A) and 1102(B), and/or the aperture defining structure 1202, electromagnetic fields are created between the electrodes 1102 and the aperture defining structure 1202. While FIG. 13 illustrates the aperture lens array 1300 as comprising two electrodes, in some embodiments the aperture lens array 1300 may only include one electrode (either electrodes 1102(A) or 1102(B)).

The aperture lens array 1300 is configured such that the configuration of the electrodes 1102 (i.e., one electrode, both electrodes, the positions of such electrodes, the geometry of such electrodes, etc.), the voltages (or lack of voltages) applied to individual ones of the electrodes 1102 and the aperture defining structure 1202, and the pattern that the first aperture 1204, the second aperture 1206, and the plurality of apertures 1208 collectively create an electromagnet field that creates a first lensing effect on the first charged particle beam and a second lensing effect on the second charged particle beam, where the first and second lensing effects are different. For example, in an embodiment of the present invention, the electromagnetic field may create a lensing effect (e.g., at least a quadrupole lensing effect) that causes the first charged particle beam 1306 and the second charged particle beam 1308 to have different focal properties.

In some embodiments, the electromagnetic field also deflects one or both of the first charged particle beam 1306 and the second charged particle beam 1308 away from the emission axis 1304. Also, while FIG. 13 illustrates the first charged particle beam 1308 as an axial beam that travels along the emission axis 1304 of the plurality of charged particles 1302, this is not required in all embodiments.

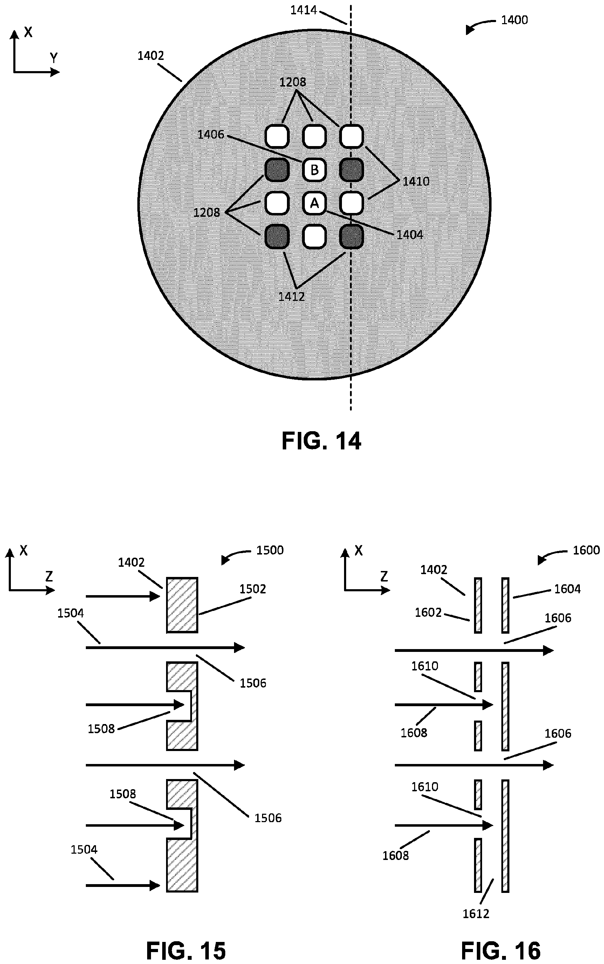

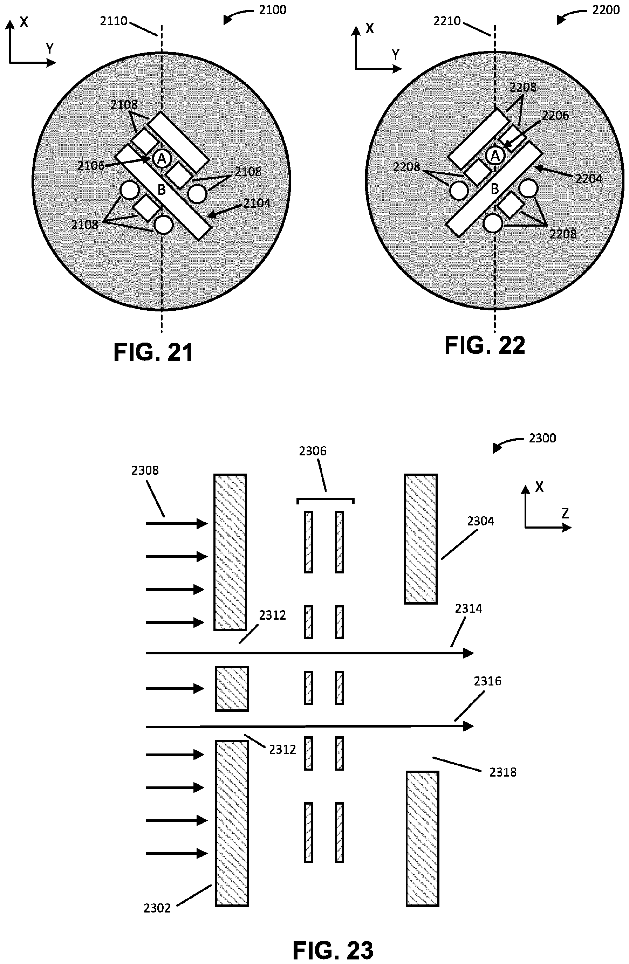

FIGS. 14-22 show example central structures which can be used in the multiple aperture assembly 2300 illustrated in FIG. 23. While these example central structures show example combinations, configurations, and/or patterns of holes, cavities, or combinations thereof. For example, the optimal shapes of individual holes and/or cavities for a particular aperture pattern may be different from those shown in FIGS. 14-22 (e.g., circular, polynomial, non-symmetrical, a shape that is slightly deformed/modified in order to zero 4-fold astigmatism by octupole fields, etc.).

Specifically, FIG. 14 illustrates an example aperture defining structure 1400 for an example aperture lens array that includes a combination of holes and cavities. The example aperture defining structure 1402 defines (i) a first aperture 1404 that allows a first charged particle beam to pass through the at least one aperture defining structure 1402, (ii) a second aperture 1406 that allows a second charged particle beam to pass through the at least one aperture defining structure 1402, and (iii) plurality of other apertures 1408. The first aperture 1404, the second aperture 1406, and the plurality of apertures 1408 collectively form a pattern that induces an electromagnetic field that applies a lensing effect (e.g., at least a quadrupole lensing effect) to at least the second charged particle beam when voltages are applied to at least the aperture defining structure 1400 and electrodes 2302 and 2304 during use of the multiple aperture assembly 2300. In some embodiments, the aperture lens structure 1402 comprises a single physical component that defines each of the first aperture 1404, the second aperture 1406, and the plurality of apertures 1408. However, in other embodiments the aperture lens structure 1402 may comprise two or more component physical structures.

FIG. 14 illustrates an example embodiment in which five of the plurality of other apertures 1408 correspond to holes 1210, and four of the plurality of other apertures 1408 correspond to cavities 1412. However, in other embodiments the plurality of other apertures 1408 may comprise other combinations and/or patterns of holes and cavities, including embodiments where all of the plurality of other apertures 1408 correspond to one of holes (e.g., the aperture defining structure illustrated in FIG. 12) or cavities, exclusively. In the example embodiment shown in FIG 14, each of the first aperture 1404, the second aperture 1406, and two other apertures 1408 are positioned along a line 1414 of the aperture defining structure 1402.

FIG. 15 illustrates a cross section 1500 of example aperture structure 1402 that comprises a single physical structure 1502. Specifically, FIG. 15 shows a cross section of an embodiment of the example aperture structure 1402 of FIG. 14, with the cut of the cross section aligning with the line 1414. A first portion of the charged particles 1504 are allowed to pass through the physical structure 1502 via holes 1506. FIG. 15 further shows a second portion of the charged particles 1504 are allowed to pass into cavities 1508 that prevent them from passing through the physical structure 1502.

FIG. 16 illustrates a cross section 1600 of example aperture structure 1402 that comprises a first physical structure 1602 and a second physical structure 1604. Specifically, FIG. 16 shows a cross section of an embodiment of the example aperture structure 1402 where it is comprised of two structures (e.g., foils), with the cut of the cross section aligning with the line 1414. FIG. 16 illustrates holes 1606 in the example aperture structure 1402 as corresponding to complementary apertures in the first physical structure 1602 and a second physical structure 1604 that together allow a first portion of the charged particles 1608 to pass through the aperture structure 1402. FIG. 16 also illustrates cavities 1610 as corresponding to apertures in the first physical structure 1602 that do not have a complimentary aperture in the second physical structure 1604. In other words, the cavities 1610 are configured such that a second portion of the charged particles 1608 is allowed to pass into a space 1612 between the first physical structure 1602 and the second physical structure 1604, but are not allowed to pass through the aperture structure 1402.

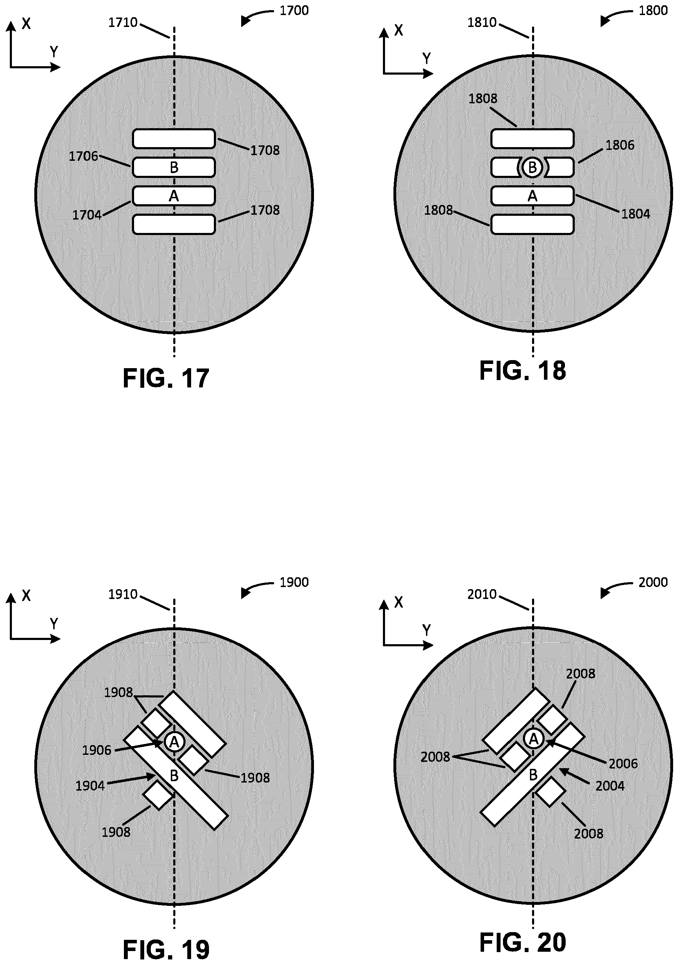

FIGS. 17 and 18 illustrate a pair of component physical structures that can be used to form an aperture defining structure 2306 in the aperture lens array 2300 illustrated in FIG. 23. Specifically, FIG. 17 illustrates an example first component physical structure 1700 of an example aperture defining structure comprising two physical structures. The example first component physical structure 1700 defines (i) a first aperture 1704 that allows a first charged particle beam to pass through the first component physical structure 1700, (ii) a second aperture 1706 that allows a second charged particle beam to pass through first component physical structure 1700, and (iii) plurality of other apertures 1708. Each of these apertures are illustrated as having a rectangular geometry (e.g., a long slot). Such rectangular apertures are configured to create a cylindrical lensing effect on charged particles passing through them during use of the example aperture defining structure. In the example embodiment shown in FIG 17, each of the first aperture 1704, the second aperture 1706, and two apertures 1708 are positioned along a midline 1710 of the first component physical structure 1700.

FIG. 18 illustrates an example second component physical structure 1800 of an example aperture defining structure comprising two physical structures. The example second component physical structure 1800 defines (i) a first aperture 1804 that allows a first charged particle beam to pass through the second component physical structure 1800, (ii) a second aperture 1806 that allows a second charged particle beam to pass through second component physical structure 1800, and (iii) plurality of other apertures 1808. Apertures 1804 and 1808 are shown as having a rectangular geometry, similar to the apertures defined by the first component physical structure 1700 illustrated in FIG. 17. The second aperture 1806 is illustrated in FIG. 18 as combining both a rectangular geometry and a circular geometry. In other words, the second aperture 1806 is shown as being a circular aperture centrally positioned and overlaid with an aperture having a rectangular geometry. This combination of the geometry of the second aperture 1706 and the second aperture 1806 cause a net quadrupole lensing effect to be applied to the charged particle beam B as it passes through the second apertures 1706 and 1806. Similarly, the geometries of the first aperture 1704 and the first aperture 1804 cause a no net lensing effect to be applied to the charged particle beam A. In the example embodiment shown in FIG 18, each of the first aperture 1804, the second aperture 1806, and two apertures 1808 are positioned along a midline 1810.

FIGS. 19 and 20 illustrate a pair of component physical structures that can be used to form an aperture defining structure 2306 in the aperture lens array 2300 illustrated in FIG. 23. Specifically, FIG. 19 illustrates an example first component physical structure 1900 of an example aperture defining structure comprising two physical structures. The example first component physical structure 1900 defines (i) a first aperture 1904 that allows a first charged particle beam to pass through the first component physical structure 1900, (ii) a second aperture 1906 that allows a second charged particle beam to pass through first component physical structure 1900, and (iii) plurality of other apertures 1908. Such apertures are configured to create a quadrupole lensing effect on charged particles passing through the second aperture 1906 during use of the example aperture defining structure. In the example embodiment shown in FIG 19, each of the first aperture 1904, the second aperture 1906, and other apertures 1908 are positioned along a midline 1910 of the first component physical structure 1900.

FIG. 20 illustrates an example second component physical structure 2000 of an example aperture defining structure comprising two physical structures. The example second component physical structure 2000 defines (i) a first aperture 2004 that allows a first charged particle beam to pass through the second component physical structure 2000, (ii) a second aperture 2006 that allows a second charged particle beam to pass through second component physical structure 2000, and (iii) plurality of other apertures 2008. Apertures 2004 and 2008 are shown as having a geometry similar to the apertures defined by the first component physical structure 2000 illustrated in FIG. 20. The combination of the geometry of the second aperture 1906 and the second aperture 2006 causes no net lensing effect to be applied to the charged particle beam A Similarly, the geometries of the first aperture 1904 and the first aperture 2004 cause a net quadrupole lensing effect to be applied to the charged particle beam B as it passes through the second apertures 1906 and 2006. In the example embodiment shown in FIG 20, each of the first aperture 1804, the second aperture 2006, and two apertures 2008 are positioned along a midline 2010.

FIGS. 21 and 22 illustrate a pair of component physical structures that can be used to form an aperture defining structure 2306 in the aperture lens array 2300 illustrated in FIG. 23. Specifically, FIG. 21 illustrates an example first component physical structure 2100 of an example aperture defining structure comprising two physical structures. The example first component physical structure 2100 defines (i) a first aperture 2104 that allows a first charged particle beam to pass through the first component physical structure 2100, (ii) a second aperture 2106 that allows a second charged particle beam to pass through first component physical structure 2100, and (iii) plurality of other apertures 2108. Each of these apertures are illustrated as having a rectangular geometry (e.g., a long slot). Such rectangular apertures are configured to create a cylindrical lensing effect on charged particles passing through them during use of the example aperture defining structure. In the example embodiment shown in FIG 21, each of the first aperture 2104, the second aperture 2106, and two apertures 2108 are positioned along a midline 2110 of the first component physical structure 2100.

FIG. 22 illustrates an example second component physical structure 2200 of an example aperture defining structure comprising two physical structures. The example second component physical structure 2200 defines (i) a first aperture 2204 that allows a first charged particle beam to pass through the second component physical structure 2200, (ii) a second aperture 2206 that allows a second charged particle beam to pass through second component physical structure 2200, and (iii) plurality of other apertures 2208. Apertures 2204 and 2208 are shown as having a rectangular similar to the apertures defined by the first component physical structure 2100 illustrated in FIG. 21. This combination of the geometry of the second aperture 2106 and the second aperture 2206 causes no net lensing effect to be applied to the charged particle beam A. Similarly, the geometries of the first aperture 2104 and the first aperture 2204 cause a net quadrupole lensing effect to be applied to the charged particle beam B that passes through the second apertures 2106 and 2206. In the example embodiment shown in FIG 22, each of the first aperture 2204, the second aperture 2206, and two apertures 2208 are positioned along a midline 2210.

FIG. 23 illustrates a cross section of an example aperture lens array 2300 comprising a first electrode 2302, a second electrode 2304, and an aperture defining structure 2306.

FIG. 23 shows charged particles 2308 being emitted toward a first electrode 2302. The first electrode 2302 is shown as defining a pair of apertures 2312 that allow a portion of the charged particles 2308 to pass through the first electrode 2302. In some embodiments, the first electrode 2302 may correspond to an electrically conductive foil that defines the two apertures 2312. A first portion of the charged particles 2308 pass through both a first aperture becoming first charged particle beam 2314. Another portion of the charged particles 2308 pass through both the second aperture becoming second charged particle beam 2316.

In all embodiments, the aperture lens array 2300 includes a second electrode 2304 positioned such that the aperture defining structure 2306 is between the two electrodes. The second electrode 2304 may correspond to a disk electrode defining an aperture 2318 that allows the first charged particle beam 2314 and the second charged particle beam 2316 pass through the second electrode 2304.

When certain voltages are applied to both the electrodes 2302 and 2304, and/or aperture defining structure 2306, electromagnetic fields are created between the electrodes 2302 and 2304. The electromagnetic fields and the pattern that the apertures defined by the aperture defining structure 2306 collectively create a lensing effect that causes the first charged particle beam 2314 and the second charged particle beam 2316 to have different focal properties.

While non-limiting, a simple representative calculation can be used to illustrate the performance of some embodiments of the present invention having different array patterns for the upstream and downstream components (e.g., the embodiment depicted in FIGS. 17 and 18, the embodiment depicted in FIGS. 19 and 20, the embodiment depicted in FIGS. 21 and 22). To enable this simple representative calculation, the following paragraphs assume that (a) $|\phi_0(z)| \ll U$ everywhere, (b) the field component $E_z = -\phi_0'(z)$ close to the aperture array plates changes from $E_{up}$ (i.e., the nonzero electric field above the aperture defining structure 2306) to 0 in above the aperture defining structure 2306, (c) the field component $E_z = -\phi_0'(z)$ close to the aperture array plates changes from 0 to $E_{low}$ (i.e., the nonzero electric field below the aperture defining structure 2306) below the aperture defining structure 2306, and (d) the field between the array plates is a zero field in at least one position between the array plates (e.g. the plates in FIG. 17 and 18).

In the simple representative calculation, the electrostatic potential up to order 2 in the x and y direction can be generally expressed as:

$$\phi(x, y, z) = U + \phi_0(z) + p\,\phi_0''(z)\,x^2 + q\,\phi_0''(z)\,y^2 + \phi_2(z)(x^2 - y^2),$$

$$(1)$$

for an electrostatic potential that is mirror symmetric in the x-z plane and the y-z plane. In expression (1), $U$ represents the electron energy above the aperture lens array 2300, and the other terms are induced by the voltages applied to both the electrodes 2302 and 2304, and/or aperture defining structure 2306. The Laplace equation ($\Delta\phi = 0$) for this electrostatic potential dictates that $p + q = -1/2$. In some examples, this corresponds to $p = q = -1/4$ for a round aperture lens, and p = -1/2 and $q = 0$ for a cylinder lens which focuses in the x-z plane (such as the embodiment depicted in FIG. 17).

According to the simple representative calculation, the upstream component of the aperture defining structure 2306 invokes lens strengths:

$$\kappa_{x,up} = f_{x,up}^{-1} = U^{-1}\left(-p_{up}E_{up} - Q_{up}\right); \qquad \text{and} \qquad \kappa_{y,up} = f_{y,up}^{-1} = U^{-1}\left(-q_{up}E_{up} + Q_{up}\right); \qquad (2)$$

Similarly, the downstream component of the aperture defining structure 2306 invokes lens strength:

$$\kappa_{x,low} = f_{x,low}^{-1} = U^{-1}(p_{low}E_{low} - Q_{low}); \text{ and } \kappa_{y,low} = f_{y,low}^{-1} = U^{-1}(q_{low}E_{low} + Q_{low}); \qquad (3)$$

In these equations, $f_x$ and $f_y$ are the focal distances in the x-z plane and the y-z plane, respectively, and $U^{-1}Q_{up}$ and $U^{-1}Q_{low}$ are the quadrupole lens strengths induced by the quadrupole potential $\phi_2(z)(x^2-y^2)$.

In some preferred embodiments, $E_{up} = E_{low} \equiv E$. In such embodiments, the total lens strengths simplify to:

$$\kappa_x = \kappa_{x,up} + \kappa_{x,low} = U^{-1}\left((p_{low} - p_{up})E - Q\right); \qquad (5)$$

and

$$\kappa_y = \kappa_{y,up} + \kappa_{y,low} = U^{-1}\left((q_{low} - q_{up})E + Q\right). \qquad (6)$$

Because $p_{up} + q_{up} = p_{low} + q_{low} = -1/2$, it follows that $\kappa_y = -\kappa_x$ in such embodiments, meaning that there is only a pure quadrupole lens action.

In embodiments of aperture lens array 1900 where the electromagnetic field is the same on both sides of the physical structures 1700 and 1800, the lensing effects caused by the first charged particle beam 1908 traveling through the first aperture 1704 are canceled and/or otherwise negated by the lensing effects caused by the first charged particle beam 1908 traveling through the first aperture 1804. Additionally, in such an embodiment, the lensing effects caused by the second charged particle beam 1910 traveling through the second aperture 1706 and the lensing effects caused by the second charged particle beam 1910 traveling through the second aperture 1806 combine to form at least a quadrupole lensing effect.

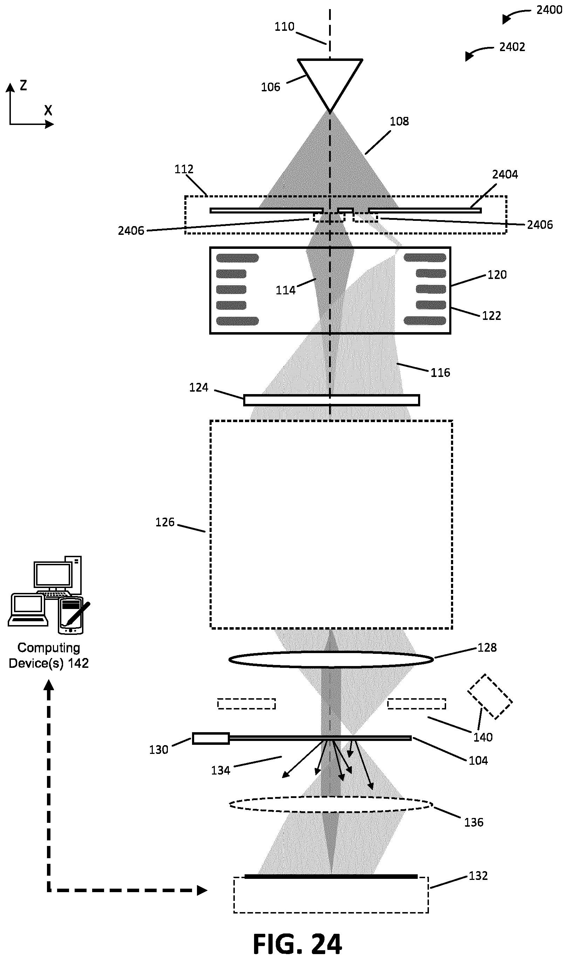

FIG. 24 is an illustration of an example embodiment 2400 of bifocal multibeam charged particle system(s) 100 for investigating a sample 104 where the bifocal beamformer 112 comprises a beamsplitting mechanism 2404 and one or more focusing devices 2406.

The example bifocal multibeam charged particle system(s) 2402 includes a charged particle source 106 that emits a plurality of charged particles 108 along an emission axis 110 and towards the bifocal beamformer 112. In the illustrated embodiment of the present invention, the bifocal beamformer 112 is shown as comprising at least (i) a beamsplitting mechanism 2404 that splits the plurality of charged particles 108 into the first charged particle beam 114 and the second charged particle beam 116, and (ii) one or more focusing devices 2406 configured to modify the focal properties of one or both of the charged particle beams such that the two beams do not have the same corresponding focal planes. In some embodiments, the one or more focusing devices 2406 are further configured to cause one or both of the first charged particle beam 114 and the second charged particle beam 116 to be deflected away from the emission axis 110.

In FIG. 24, the beamsplitting mechanism 2404 is shown as corresponding to a physical structure that defines a first aperture that allows the first charged particle beam 114 to pass through the beamsplitting mechanism 2404, and a second aperture that allows the second charged particle beam 116 to pass through the beamsplitting mechanism 2404. FIG. 24 further illustrates the one or more focusing devices 2406 as optionally corresponding to two lenses. However, in other embodiments the focusing devices 2406 may correspond to three or more lenses, a single lens that modifies only one of the charged particle beams, a single lens with a high degree of aberration such that the two charged particle beams that pass through the lens Additionally, while FIG. 24 illustrates the beamsplitting mechanism 2404 as being upstream of the one or more focusing devices 2406, in other embodiments of example bifocal multibeam charged particle systems 2402 the beamsplitting mechanism 2404 may be downstream of the one or more focusing devices 2406. Alternatively, in some embodiment some of the focusing devices 2406 may be upstream of the beamsplitting mechanism 2404, while others of the focusing devices 2406 may be downstream of the beamsplitting mechanism 2404.

FIG. 24 illustrates the bifocal beamformer 112 as being positioned upstream of focusing component 120 that is configured to apply a lensing action that focuses at least one of the first charged particle beam 114 and the second charged particle beam 116. In the example bifocal multibeam charged particle system(s) 2402 shown in FIG.24, the focusing component corresponds to an accelerator 122 that accelerates/decelerates, focuses, and/or directs the first charged particle beam 114 and the second charged particle beam 116 towards a focusing column 126.

The focusing column 126 and the objective lens 128 focus the charged particle beams 114 and 116 so that they are incident on sample 104. Specifically, FIG. 24 illustrates the focusing column 126 focusing the second charged particle beam 116 so that is focused on the sample 104 and the first charged particle beam 114 such that it is not focused on the sample 104. In some embodiments, the focal planes of the first charged particle beam 114 and the second charged particle beam 116 are modified such that one of the beams is focused at a plane at or near the sample 104 and the other charged particle beam is focused at a plane which is located at least 0.1%, 1%, 10%, or 100 % of the objective lens focal distance above or below the sample 104. Alternatively or in addition, the focal planes of the first charged particle beam 114 and the second charged particle beam 116 may be modified such that the diameter of one of the charged particle beams at the sample 104 is at least one of 50, 100, 500, or 1000 times greater than the diameter of the other charged particle beam at the sample.

Examples of inventive subject matter according to the present disclosure are described in the following enumerated paragraphs.

A1. A method for investigating a sample, the method comprising emitting a plurality of charged particles toward the sample; forming the plurality of charged particles into a first charged particle beam and a second charged particle beam; modifying the focal properties of at least one of the first charged particle beam and the second charged particle beam.

A1.1. The method of paragraph A1, wherein modifying the focal properties of at least one of the first charged particle beam and the second charged particle beam comprises modifying one or more of the first charged particle beam and the second charged particle beams such that: the first charged particle beam has a first focal plane; and the second charged particle beam has a second focal plane that is different from the first focal plane.

A1.1.1. The method of paragraph A1.1, wherein modifying the focal properties of at least one of the first charged particle beam and the second charged particle beam comprises modifying one or more of the first charged particle beam and the second charged particle beams such that: the first charged particle beam has a focal plane at a plane at or near the sample; and the second charged particle beam does not have a focal plane at the plane at or near the sample.

A1.1.2. The method of paragraph A1.1, wherein modifying the focal properties of at least one of the first charged particle beam and the second charged particle beam comprises modifying one or more of the first charged particle beam and the second charged particle beams such that: the second charged particle beam has a focal plane at a plane at or near the sample; and the first charged particle beam does not have a focal plane at the plane at or near the sample.

A1.2. The method of any of paragraphs A1-A1.1.2, wherein modifying the focal properties of at least one of the first charged particle beam and the second charged particle beam comprises applying a round lens action to one of the first charged particle beam and the second charged particle beam.

A1.2.1. The method of paragraph A1.2, wherein modifying the focal properties of at least one of the first charged particle beam and the second charged particle beam comprises applying the round lens action to both of the first charged particle beam and the second charged particle beam.

A1.2.1.1. The method of paragraph A1.2.1, wherein the round lens action applied to the first charged particle beam is different from the round lens action applied to the second charged particle beam.

A1.3. The method of any of paragraphs A1-A1.2.1.1, wherein modifying the focal properties of at least one of the first charged particle beam and the second charged particle beam comprises applying at least a quadrupole lens action to one of the first charged particle beam and the second charged particle beam.

A1.4. The method of any of paragraphs A1-A1.3, wherein the first charged particle beam is an axial beam that travels along on an emission axis of the plurality of charged particles, and the second charged particle beam is a non-axial beam.

A1.5. The method of any of paragraphs A1-A1.4, wherein the second charged particle beam is an axial beam that travels along on an emission axis of the plurality of charged particles, and the first charged particle beam is a non-axial beam.

A2. The method of any of paragraphs A1-A1.5, wherein the charged particles are electrons and the charged particle beams are electron beams.

A3. The method of any of paragraphs A1-A2, wherein a second beam diameter of the second charged particle beam at the sample is at least one of 5, 10, 20, 50, 100, 500, or 1000 times greater than a first beam diameter of the first charged particle beam at the sample.

A3.1. The method of paragraph A3, wherein the second beam diameter is at least one of 5, 10, 20, 50, 100, 500, or 1000 times greater than a first beam diameter at or proximate to each crossover point of the first charged particle beam.

A4. The method of any of paragraphs A1-A3.1, wherein the first charged particle beam is tilted and/or shifted with respect to the second charged particle beam at the sample.

A5. The method of any of paragraphs A1-A4, wherein the first charged particle beam and the second charged particle beam are mutually coherent beams.

A6. The method of any of paragraphs A1-A5, further comprising accelerating each of the first charged particle beam and the second charged particle beam to a final energy with an accelerator.

A7. The method of any of paragraphs A1-A5, further comprising accelerating the plurality of charged particles to a final energy with an accelerator.

A8. The method of any of paragraphs A1-A7, wherein each of the forming the plurality of charged particles and the modifying of the focal properties is performed by a bifocal beamformer.

A8.1. The method of paragraph A8 when dependent from A6, wherein the bifocal beamformer is located above an accelerator.

A8.2. The method of paragraph A8 when dependent from A7, wherein the bifocal beamformer is located below an accelerator.

A8.3. The method of any of paragraphs A8-A8.2, wherein the bifocal beamformer distorts the second charged particle beam.

A8.4. The method of any of paragraphs A8-A8.3, wherein the bifocal beamformer changes the focal properties of the second charged particle beam.

A8.5. The method of any of paragraphs A8-A8.4, wherein the bifocal beamformer causes the second charged particle beam to not be a cylindrical beam.

A8.5.1. The method of paragraph A8.5, further comprising causing the second charged particle beam to be a cylindrical beam with a stigmator.

A8.6. The method of any of A8-A8.5.1.1, wherein the bifocal beamformer causes the second charged particle beam to have one or more aberrations.

A8.6.1. The method of paragraphs A8.6, wherein at least one of the one or more aberrations is not a parasitic aberration.

A8.6.2. The method of any of paragraphs A8.6-8.6.1, wherein the bifocal beamformer is positioned and/or configured to cause at least one of the one or more aberrations to correct another aberration in the system.

A8.7. The method of any of paragraphs A8-A8.6.2, wherein the bifocal beamformer is further configured to deflect at least one of the first charged particle beam and the second charged particle beam away from an emission axis of the plurality of charged particles.

A9. The method of any of paragraphs A8-A8.7, wherein the bifocal beamformer comprises a MEMS device configured to generate at least a quadrupole lensing effect that at least partially causes the modifying of the focal properties of at least one of the first charged particle beam and the second charged particle beam.

A9.1. The method of paragraph A9, wherein the MEMS device comprises a structure defining a first aperture and a second aperture, and wherein the first charged particle beam passes through the first aperture and the second charged particle beam passes through the second aperture.

A9.1.1. The method of paragraph A9.1, wherein the first aperture has the same radius as the second aperture.

A9.1.2. The method of paragraph A9.1, wherein the first aperture has a smaller radius than the second aperture.

A9.1.3. The method of paragraph A9.1, wherein the first aperture has a greater radius than the second aperture.

A9.1.4. The method of any of paragraphs A9.1-A9.1.3, wherein the MEMS device comprises a surface layer facing the plurality of charged particles, and wherein the first aperture and the second aperture are defined by the surface layer.

A9.1.4.1. The method of paragraph A9.1.4, wherein the surface layer is a foil.

A9.1.5. The method of any of paragraphs A9.1-A9.1.4.1, wherein the first aperture is an axial aperture positioned on an emission axis of the plurality of charged particles, and the second aperture is a non-axial aperture.

A9.1.6. The method of any of paragraphs A9.1-A9.1.4.1, wherein the second aperture is an axial aperture positioned on an emission axis of the plurality of charged particles, and the first aperture is a non-axial aperture.

A9.2. The method of any of paragraphs A9-A9.1.5, wherein the MEMS device comprises one or more electrodes.

A9.2.1. The method of paragraph A9.2, wherein when corresponding voltages are applied to the one or more electrodes, the one or more electrode generates an electromagnetic field that at least partially applies the at least the quadrupole lensing effect.

A9.2.1. The method of any of paragraphs A9.2-A9.2.1, wherein at least one of the one or more electrodes is grounded.

A9.2.2. The method of any of paragraphs A9.2-A9.2.1 when dependent from A9.1.4, wherein the MEMS device comprises an insulating layer that is opposite the surface layer.

A9.2.2.1. The method of paragraph A9.2.2, wherein the one or more electrodes are located in an electrode layer positioned between the insulating layer and the surface layer.

A9.2.3. The method of any of paragraphs A9.2-A9.2.2.1 wherein the one or more electrodes comprise four electrodes.

A9.2.4. The method of any of paragraphs A9.2-A9.2.2.1 wherein the one or more electrodes comprise seven electrodes.

A9.3. The method of any of paragraphs A9-A9.2.4, wherein the at least the quadrupole lensing effect is one of a 12-field lensing effect, 16-field lensing effect, or 24-field lensing effect.

A9.4. The method of any of paragraphs A9-A9.3, wherein the at least the quadrupole field does not cause the focal plane of the first charged particle beam to be changed.

A9.5. The method of any of paragraphs A9-A9.4, wherein the MEMS device is further configured to generate one or more dipole fields.

A9.5.1. The method of paragraph A9.5, wherein the one or more dipole fields cause at least one of the charged particle beams to be deflected in a direction perpendicular to the emission axis.

A9.6. The method of any of paragraphs A9-A9.5.1, wherein the quadrupole lensing effect applies: a positive lens effect to the first charged particle beam in a first meridional plane of the first charged particle beam; and a negative lensing effect to the first charged particle beam in a second meridional plane of the first charged particle beam, wherein the first meridional plane is perpendicular to the second meridional plane.

A9.6.1. The method of paragraph A9.6, wherein a first change of the focal plane of the first charged particle beam in the first meridional plane caused by the quadrupole field is different than a second change of the focal plane of the first charged particle beam in the second meridional plane caused by the quadrupole field.

A9.7. The method of any of paragraphs A9-A9.5.1, wherein the quadrupole lensing effect applies: a positive lens effect to the second charged particle beam in a first meridional plane of the second charged particle beam; and a negative lensing effect to the second charged particle beam in a second meridional plane of the second charged particle beam, wherein the first meridional plane is perpendicular to the second meridional plane.

A9.7.1. The method of paragraph A9.7, wherein a first change of the focal plane of the second charged particle beam in the first meridional plane caused by the quadrupole field is different than a second change of the focal plane of the second charged particle beam in the second meridional plane caused by the quadrupole field.

A10. The method of any of paragraphs A8-A8.6.2, wherein the bifocal beamformer comprises: a physical structure defining a first aperture and a second aperture, wherein the first charged particle beam passes through the first aperture and the second charged particle beam passes through the second aperture; and a lens positioned and/or configured to adjust the focal planes of the at least one of the first charged particle beam and the second charged particle beam such that they have different focal planes.

A10.1. The method of paragraph A10, wherein the first charged particle beam passes through the first aperture and the second charged particle beam passes through the second aperture.

A10.2. The method of any of paragraphs A10-A10.1, wherein the lens is an einzel lens.

A10.3. The method of any of paragraphs A10-A10.2, wherein the lens is positioned above the physical structure.

A10.4. The method of any of paragraphs A10-A10.2, wherein the lens is positioned below above the physical structure.

A10.5. The method of any of paragraphs A10-A10.4, wherein the lens is positioned and/or configured to adjust the focal planes of the second charged particle beam.

A10.5.1. The method of paragraph A10.5, wherein the lens is not positioned and/or configured to adjust the focal planes of the first charged particle beam.

A11. The method of any of paragraphs A6-A6.5, wherein the bifocal beamformer comprises at least one physical structure that defines: a first aperture that allows the first charged particle beam to pass through the at least one physical structure; a second aperture that allows the second charged particle beam to pass through the at least one physical structure; and plurality of other apertures.

A11.1. The method of paragraph A11, wherein the first aperture, the second aperture, and the plurality of other apertures form a pattern that creates an electromagnetic field that applies a lensing effect to the second charged particle beam during use of the bifocal beamformer.

A11.1.1. The method of paragraph A11.1, wherein the first aperture, the second aperture, and the plurality of other apertures form a pattern that creates an electromagnetic field that applies at least a quadrupole lensing effect to the second charged particle beam during use of the bifocal beamformer.

A11.1.1.1. The method of paragraph A11.1.1, wherein the electromagnetic field does not apply the quadrupole lensing effect to the first charged particle beam during use of the bifocal beamformer.

A11.1.2. The method of any of paragraphs A11.1-A11.1.1.1, wherein the first aperture, the second aperture, and the plurality of other apertures form a pattern that creates an electromagnetic field that applies a circular lensing effect to the first charged particle beam during use of the bifocal beamformer.

A11.1.2.1. The method of paragraph A11.1.2, wherein the plurality of other apertures form a pattern that creates an electromagnetic field that applies at least a circular lensing effect to the second charged particle beam during use of the bifocal beamformer.

A11.1.3. The method of any of paragraphs A11.1-A11.2.1, wherein the lensing effect applied by the electromagnetic field at least partially causes the modifying of the focal planes of at least one of the first charged particle beam and the second charged particle beam.

A11.1.3.1. The method of paragraph A11.1.3, wherein the electromagnetic field does change the focal planes of the first charged particle beam.

A11.3. The method of any of paragraphs A11-A11.2.1, wherein at least one aperture of the plurality of apertures is a hole.

A11.3.1. The method of paragraph A11.3, wherein the hole comprises:

an entrance defined in a first surface of the at least one physical structure, the first surface facing the plurality of charged particles; an exit defined in a second surface of the at least one physical structure that is opposite the first surface; and an empty volume that connects the entrance and the exit.

A11.3.1.1. The method of paragraph A11.3.1, wherein the first surface and the second surface are each surfaces of a single physical structure.

A11.3.1.2. The method of paragraph A11.3.1, wherein the first surface and the second surface are each surfaces of a different physical structures.

A11.4. The method of any of paragraphs A11-A11.3.1.2, wherein at least one aperture of the plurality of apertures is a cavity.

A11.4.1. The method of paragraph A11.4, wherein the cavity comprises: an entrance defined in a first surface of the at least one physical structure, the first surface facing the plurality of charged particles; and an empty volume in communication with the entrance and defined by the at least one physical structure, wherein the at least one physical structure defines the empty volume such that a charged particle of the plurality of charged particles that enters the empty volume via the entrance does not pass through the bifocal beamformer.

A11.4.1.1. The method of paragraph A11.4.1, wherein the cavity is defined by a single physical structure.

A11.4.1.2. The method of paragraph A11.4.1, wherein the cavity is defined by multiple physical structures.

A11.5. The method of any of paragraphs A11.3-A11.4.1.2, wherein the plurality of apertures comprises a combination of holes and cavities.

A11.6. The method of any of paragraphs A11-A11.5, wherein the geometry of at least one of the first aperture, the second aperture, or an aperture of the plurality of apertures is circular.

A11.7. The method of any of paragraphs A11-A11.5, wherein the geometry of at least one of the first aperture, the second aperture, or an aperture of the plurality of apertures is rectangular.

A11.7.1. The method of any of paragraphs A11-A11.5, wherein the geometry of at least one of the first aperture, the second aperture, or an aperture of the plurality of apertures is a square.

A11.7.2. The method of any of paragraphs A11-A11.5, wherein the geometry of at least one of the first aperture, the second aperture, or an aperture of the plurality of apertures has rounded corners.

A11.8. The method of any of paragraphs A11-A11.7.2, wherein the geometries of the first aperture, the second aperture, and the plurality of apertures is not uniform.

A11.9. The method of any of paragraphs A11-A11.8, wherein the sizes of the first aperture, the second aperture, and the plurality of apertures is not uniform.

A11.10. The method of any of paragraphs A11-A11.9, wherein the bifocal beamformer further comprises a first electrode configured to receive a first applied voltage.

A11.10.1. The method of paragraph A11.10, wherein the first electrode comprises a physical structure that at least partially defines an electrode entrance aperture that allows at least a portion of the plurality of charged particles to pass through the first electrode.

A11.10.1.1. The method of paragraph A11.10.1, wherein the electrode entrance aperture is a first electrode entrance aperture that allows a first portion of the plurality of charged particles to pass through the first electrode, and the second electrode further defines a second electrode entrance aperture that allows a second portion of the plurality of charged particles to pass through the first electrode.

A11.10.2. The method of any of paragraphs A11.10-A11.10.1.1, wherein the first electrode is upstream of the first aperture, the second aperture, and the plurality of apertures.

A11.10.3. The method of any of paragraphs A11.10-A11.10.2, wherein the first electrode is a disk shaped electrode.

A11.10.4. The method of any of paragraphs A11.10-A11.10.2, wherein the bifocal beamformer further comprises a second electrode configured to receive a second applied voltage.

A11.10.4.1. The method of paragraph A11.10.4, wherein the first voltage is different from the second voltage.

A11.10A.2. The method of paragraph A11.10A, wherein the first voltage and the second voltage are different.

A11.10.4.3. The method of any of paragraphs A11.10.4-A11.10.4.2, wherein the second electrode comprises a physical structure that at least partially defines an electrode exit aperture that at least one of the first charged particle beam and the second charged particle beam to pass through the second electrode.

A11.10.4.3.1. The method of paragraph A11.10.4.3, wherein the electrode exit aperture is a first electrode exit aperture that allows the first charged particle beam to pass through the second electrode, and the second electrode further comprises a second electrode exit aperture that allows the second charged particle beam to pass through the second electrode.

A11.10.4.3. The method of any of paragraphs A11.10.4-A11.10.4.3.1, wherein the second electrode is positioned downstream of the first aperture, the second aperture, and the plurality of apertures.

A12. The method of any of paragraphs A8-A8.6.2, wherein the bifocal beamformer comprises a biprism that defines a hole, and which is positioned and/or configured to split the plurality of charged particles into the first charged particle beam and the second charged particle beam.

A13. The method of any of paragraphs A8-A8.6.2, wherein laser pattern fringes are used to split the plurality of charged particles into the first charged particle beam and the second charged particle beam.

A14. The method of any of paragraphs A1-A13, wherein the second charged particle beam is focused at a different plane located above the sample.

A13.1. The method of paragraph A13, wherein the different plane is located at least 0.1%, 1%, 10%, or 100% of the objective lens focal distance above the sample.

A14. The method of any of paragraphs A1-A13, wherein the second charged particle beam is focused at a different plane located below the sample.

A14.1. The method of paragraph A14, wherein the different plane is located at least at least 0.1%, 1%, 10%, or 100% of the objective lens focal distance below the sample.

A15. The method of any of paragraphs A13-A14.1, wherein the distance between the plane at or near the sample and the different plane is at least 0.1%, 1%, 10%, or 100% of the objective lens focal distance.

A16. The method of any of paragraphs A1-A15, wherein the second charged particle beam is a parallel beam at the sample.

B1. A method for using electron holography to investigate a sample, the method comprising emitting a plurality of electrons toward the sample; forming the plurality of electrons into a first electron beam and a second electron beam;

modifying the focal properties of at least one of the first electron beam and the second electron beam such that the two electron beams have different focal planes; focusing the first electron beam such that it has a focal plane at or near the sample; focusing the second electron beam so that it is incident on the sample, and has a focal plane in the diffraction plane; and detecting an interference pattern of the first electron beam and the diffracted second electron beam in the diffraction plane.

B1.1. The method of paragraph B1, further comprising generating a hologram image of the sample based on the interference pattern of the first electron beam and the diffracted second electron beam in the diffraction plane.

B1.2. The method of any of paragraphs B1-B1.1, further comprising determining the phase of electrons diffracted by the sample based on the interference pattern of the first electron beam and the diffracted second electron beam in the diffraction plane.

B1.3. The method of any of paragraphs B1-B1.2, further comprising determining the exit wave function of the electrons leaving the sample in response to the second electron beam being incident on the sample.

B1.3.1. The method of paragraph B1.3, where determining the exit wave function comprises determining the phase and amplitude of the exit wave function of the electrons leaving the sample in response to the second electron beam being incident on the sample.

B1.3.2. The method of any of paragraphs B1.3-B1.3.1, further comprising determining the structure of the sample based on the exit wave function.

B1.3.2.1. The method of paragraph B1.3.2, wherein the sample is a crystal, and determining the structure of the sample comprises determining the crystal lattice of the sample based on the exit wave function.

B2. The method of any of paragraphs B1-B1.3.2.1, wherein one of the first electron beam and the second electron beam is an axial beam that travels along an emission axis of the plurality of charged particles.

B3. The method of any of paragraphs B1-B2, wherein the diffraction plane corresponds to the first focal plane of the second electron beam downstream of the sample.

B4. The method of any of paragraphs B1-B3, wherein the first electron beam and the second electron beam are coherent.

B4. The method of any of paragraphs B1-B3, wherein the first electron plane passes through an aperture in the sample.

B4.1. The method of paragraph B4, wherein the method further comprises, burning the aperture in the sample with one of an electron beam and an ion beam.

B5. The method of any of paragraphs B1-B3, wherein the first electron beam passes through a thin region of the sample such that there is insufficient scattering to disturb the first electron beam.

B6. The method of any of paragraphs B1-B5, wherein the second electron beam is a parallel beam at the sample.

B7. The method of any of paragraphs B1-B6, wherein a second diameter of the second electron beam is greater than 5, 10, 20, 50, and 100 times larger than a first diameter of the first electron beam.

B8. The method of any of paragraphs B1-B7, wherein the first charged particle beam is an axial beam that travels along an emission axis of the plurality of charged particles, and the second charged particle beam is a non-axial beam.

B9. The method of any of paragraphs B1-B7, wherein the second charged particle beam is an axial beam that travels along on an emission axis of the plurality of charged particles, and the first charged particle beam is a non-axial beam.

B10. The method of any of paragraphs B1-B9, wherein modifying the focal properties of at least one of the first electron beam and the second electron beam comprises applying a round lens action to one of the first electron beam and the second electron beam.

B10.1. The method of paragraph B10, wherein modifying the focal properties of at least one of the first electron beam and the second electron beam comprises applying the round lens action to both of the first electron beam and the electron particle beam.

B10.1.1. The method of paragraph B10.1, wherein the round lens action applied to the first electron beam is different from the round lens action applied to the second electron beam.

B11. The method of any of paragraphs B1-B10.1.1, wherein modifying the focal properties of at least one of the first electron beam and the second electron beam comprises applying at least a quadrupole lens action to one of the first electron beam and the second electron beam.

B11.1. The method of paragraph B11, wherein the at least a quadrupole lens action applies an astigmatism to the one of the first electron beam and the second electron beam such that it is no longer a cylindrical beam.

B11.2. The method of any of paragraphs B11-B11.1, wherein the method further comprises, applying an additional at least a quadrupole lensing effect to the one of the first electron beam and the second electron beam.

B11.2.1. The method of paragraph B11.2, wherein the additional at least a quadrupole lensing effect causes the one of the first electron beam and the second electron beam to be a cylindrical beam.

B11.2.2. The method of any of paragraphs B11.2-B11.2.1, wherein the at least a quadrupole lensing effect is applied by a corrector.

B11.2.2.1. The method of paragraph B11.2.2, wherein the corrector further applies a deflection perpendicular to an emission axis of the plurality of electrons.

B11.2.2.1.1. The method of paragraph B11.2.2.1, wherein the second electron beam is an axial beam, and the deflection causes the second electron beam to be a non-axial beam downstream of the corrector.

B11.2.2.1.2. The method of paragraph B11.2.2.1, wherein the second electron beam is a non-axial beam, and the deflection causes the second electron beam to be an axial beam downstream of the corrector.

B11.2.2.1.3. The method of paragraph B11.2.2.1, wherein the first electron beam is an axial beam, and the deflection causes the first electron beam to be a non-axial beam downstream of the corrector.

B11.2.2.1.4. The method of paragraph B11.2.2.1, wherein the first electron beam is a non-axial beam, and the deflection causes the first electron beam to be an axial beam downstream of the corrector.

B11.2.2.2. The method of any of paragraphs B11.2.2.1-B11.2.2.1.4, wherein the corrector is positioned at a focal plane of the electron beam that did not receive the at least the quadrupole lensing effect.

B12. The method of any of paragraphs B1-B11.2.2.2, wherein the plurality of electrons are split and the first electron beam and the second electron beam are modified by a MEMS device.

B12.1. The method of paragraph B12, wherein the MEMS device comprises a MEMS device of any of paragraphs F1-F12.1.

B13. The method of any of paragraphs B1-B12, wherein the plurality of electrons are split and the first electron beam and the second electron beam are modified by a multi aperture device.

B13.1. The method of paragraph B13, wherein the MEMS device comprises a MEMS device of any of paragraphs F1-F12.1.

B14. The method of any of paragraphs B1-B13, wherein the sample is a crystal.

B14.1. The method of paragraph B14, wherein the diffraction peaks in the diffraction image are Airy disks.

B15. The method of any of paragraphs B1-B14.1, wherein the electrons scattered by the sample over a specific angle are focused in the diffraction plane.

C1. A system for investigating a sample, the system comprising: a sample holder configured to hold a sample; a charged particle emitter configured to emit charged particles towards the sample; a bifocal beamformer positioned between the charged particle emitter and the sample holder, wherein the bifocal beamformer is configured to: form the plurality of charged particles into a first charged particle beam and a second charged particle beam; and modify the focal properties of at least one of the first charged particle beam and the second charged particle beam such that the first charged particle beam is focused at a plane at or near the sample and the second charged particle beam is not focused at the plane at or near the sample.

C2. The system of paragraph C1, wherein the charged particle emitter is an electron emitter configured to emit electrons toward the sample, and the charged particle beams are electron beams.

C3. The system of any of paragraphs C1-C2, wherein a second beam diameter of the second charged particle beam at the sample is at least one of 5, 10, 20, 50, 100, 500, or 1000 times greater than a first beam diameter of the first charged particle beam at the sample.

C3.1. The system of paragraph C3, wherein the second beam diameter is at least one of 5, 10, 20, 50, 100, 500, or 1000 times greater than a first beam diameter at or proximate to each crossover point of the first charged particle beam.

C4. The system of any of paragraphs C1-C3.1, wherein the first charged particle beam is tilted with respect to the second charged particle beam at the sample.

C5. The system of any of paragraphs C1-C4, wherein the first charged particle beam and the second charged particle beam are coherent beams.

C6. The system of any of paragraphs C1-C5, further comprising an accelerator.

C6.1. The system of paragraph C6, wherein the accelerator is positioned below the bifocal beamformer and configured to accelerate each of the first charged particle beam and the second charged particle beam to a final energy.

C6.2. The system of paragraph C6, wherein the accelerator is positioned above the bifocal beamformer and configured to accelerate the plurality of charged particles to a final energy.

C7. The system of any of paragraphs C1-C6.2, wherein the bifocal beamformer distorts the second charged particle beam.

C8. The system of any of paragraphs C1-C7, wherein the bifocal beamformer changes the focal planes of the second charged particle beam.

C9. The system of any of paragraphs C8-C8.4, wherein the bifocal beamformer causes one of the first charged particle beam and the second charged particle beam to not be a cylindrical beam.

C9.1. The system of paragraph C9, further comprising a corrector configured to cause the second charged particle beam to be a cylindrical beam.

C9.1.1. The system of paragraph C9.1., wherein the corrector is a stigmator.

C10. The system of any of C1-C9.1.1, wherein the bifocal beamformer causes the second charged particle beam to have one or more aberrations.

C10.1. The system of paragraphs C10, wherein at least one of the one or more aberrations is a deterministic aberration.

C10.2. The system of any of paragraphs C10-C10.1, wherein the bifocal beamformer is positioned and/or configured to cause at least one of the one or more aberrations to correct another aberration in the system.

C11. The system of any of paragraphs C1-C10.2, wherein the bifocal beamformer is further configured to deflect at least one of the first charged particle beam and the second charged particle beam away from an emission axis of the plurality of charged particles.

C12. The system of any of paragraphs C1-C11, wherein the bifocal beamformer comprises a MEMS device configured to generate at least a quadrupole field that at least partially causes the modifying of the focal properties of at least one of the first charged particle beam and the second charged particle beam.

C12.1. The system of paragraph C12, wherein the MEMS device comprises a structure defining a first aperture and a second aperture, and wherein the first charged particle beam passes through the first aperture and the second charged particle beam passes through the second aperture.

C12.1.1. The system of paragraph C12.1, wherein the first aperture has the same radius as the second aperture.

C12.1.2. The system of paragraph C12.1, wherein the first aperture has a smaller radius than the second aperture.

C12.1.3. The system of paragraph C12.1, wherein the first aperture has a greater radius than the second aperture.

C12.1.4. The system of any of paragraphs C12.1-C12.1.3, wherein the MEMS device comprises a surface layer facing the plurality of charged particles, and wherein the first aperture and the second aperture are defined by the surface layer.

C12.1.4.1. The system of paragraph C12.1.4, wherein the surface layer is a foil.

C12.1.5. The system of any of paragraphs C12.1-C12.1.4.1, wherein the first aperture is an axial aperture positioned on an emission axis of the plurality of charged particles, and the second aperture is a non-axial aperture.

C12.1.6. The system of any of paragraphs C12.1-C12.1.4.1, wherein the second aperture is an axial aperture positioned on an emission axis of the plurality of charged particles, and the first aperture is a non-axial aperture.

C12.2. The system of any of paragraphs C12.1-C12.1.6, wherein the MEMS device comprises one or more electrodes.

C12.2.1. The system of paragraph C12.2, wherein when corresponding voltages are applied to the one or more electrodes, the one or more electrode generate the at least the quadrupole field.

C12.2.1. The system of any of paragraphs C12.2-12.2.1, wherein at least one of the one or more electrodes is grounded.

C12.2.2. The system of any of paragraphs C12.2-C12.2.1 when dependent from C12.1.4, wherein the MEMS device comprises an insulating layer that is opposite the surface layer.

C12.2.2.1. The system of paragraph C12.2.2, wherein the one or more electrodes are located in an electrode layer positioned between the insulating layer and the surface layer.

C12.2.3. The system of any of paragraphs C12.2-C12.2.2.1 wherein the one or more electrodes comprise four electrodes.

C12.2.4. The system of any of paragraphs C12.2-C12.2.2.1 wherein the one or more electrodes comprise seven electrodes.

C12.3. The system of any of paragraphs C12.1-C12.2.4, wherein the at least the quadrupole field is one of a 12-field, 16-field, or 24-field.

C12.4. The system of any of paragraphs C12.1-C12.3, wherein the at least the quadrupole field does not cause the focal properties of the first charged particle beam to be changed.

C12.5. The system of any of paragraphs C12.1-C12.4, wherein the MEMS device is further configured to generate one or more dipole fields.

C12.5.1. The system of paragraph C12.5, wherein the one or more dipole fields cause at least one of the charged particle beams to be deflected in a direction perpendicular to the emission axis.

C13. The system of any of paragraphs C1-C11, wherein the bifocal beamformer comprises: a physical structure defining a first aperture and a second aperture, wherein the first charged particle beam passes through the first aperture and the second charged particle beam passes through the second aperture; and a lens positioned and/or configured to adjust the focal properties of the at least one of the first charged particle beam and the second charged particle beam such that they have different focal properties.

C13.1. The system of paragraph C13, wherein the first charged particle beam passes through the first aperture and the second charged particle beam passes through the second aperture.

C13.2. The system of any of paragraphs C13-C13.1, wherein the lens is an einzel lens.

C13.3. The system of any of paragraphs C13-C13.2, wherein the lens is positioned above the physical structure.

C13.4. The system of any of paragraphs C13-C13.2, wherein the lens is positioned below above the physical structure.

C13.5. The system of any of paragraphs C13-C13.4, wherein the lens is positioned and/or configured to adjust the focal properties of the second charged particle beam.

C13.5.1. The system of paragraph C13.5, wherein the lens is not positioned and/or configured to adjust the focal properties of the first charged particle beam.

C14. The system of any of paragraphs C14-C14.5, wherein the bifocal beamformer comprises at least one physical structure that defines: a first aperture that allows the first charged particle beam to pass through the at least one physical structure; a second aperture that allows the second charged particle beam to pass through the at least one physical structure; and plurality of other apertures.

C14.1. The system of paragraph C14, wherein the plurality of other apertures form a pattern that creates an electromagnetic field that applies a lensing effect to the second charged particle beam during use of the bifocal beamformer.

C14.1.1. The system of paragraph C14.1, wherein the plurality of other apertures form a pattern that creates an electromagnetic field that applies at least a quadrupole lensing effect to the second charged particle beam during use of the bifocal beamformer.

C14.1.1.1. The system of paragraph C14.1.1, wherein the electromagnetic field does not apply the quadrupole lensing effect to the first charged particle beam during use of the bifocal beamformer.

C14.1.2. The system of any of paragraphs C14.1-C14.1.1.1, wherein the plurality of other apertures form a pattern that creates an electromagnetic field that applies a circular lensing effect to the first charged particle beam during use of the bifocal beamformer.

C14.1.2.1. The system of paragraph C14.1.2, wherein the plurality of other apertures form a pattern that creates an electromagnetic field that applies at least a circular lensing effect to the second charged particle beam during use of the bifocal beamformer.

C14.1.3. The system of any of paragraphs C14.1-C14.2.1, wherein the lensing effect applied by the electromagnetic field at least partially causes the modifying of the focal properties of at least one of the first charged particle beam and the second charged particle beam.

C14.1.3.1. The system of paragraph C14.1.3, wherein the electromagnetic field does change the focal properties of the first charged particle beam.

C14.3. The system of any of paragraphs C14-C14.2.1, wherein at least one aperture of the plurality of apertures is a hole.

C14.3.1. The system of paragraph C14.3, wherein the hole comprises:

an entrance defined in a first surface of the at least one physical structure, the first surface facing the plurality of charged particles; an exit defined in a second surface of the at least one physical structure that is opposite the first surface; and an empty volume that connects the entrance and the exit.

C14.3.1.1. The system of paragraph C14.3.1, wherein the first surface and the second surface are each surfaces of a single physical structure.

C14.3.1.2. The system of paragraph C14.3.1, wherein the first surface and the second surface are each surfaces of a different physical structures.

C14.4. The system of any of paragraphs C14-C14.3.1.2, wherein at least one aperture of the plurality of apertures is a cavity.

C14.4.1. The system of paragraph C14.4, wherein the cavity comprises:

an entrance defined in a first surface of the at least one physical structure, the first surface facing the plurality of charged particles; and an empty volume in communication with the entrance and defined by the at least one physical structure, wherein the at least one physical structure defines the empty volume such that a charged particle of the plurality of charged particles that enters the empty volume via the entrance does not pass through the bifocal beamformer.

C14.4.1.1. The system of paragraph C14.4.1, wherein the cavity is defined by a single physical structure.

C14.4.1.2. The system of paragraph C14.4.1, wherein the cavity is defined by multiple physical structures.

C14.5. The system of any of paragraphs C14.3-C14.4.1.2, wherein the plurality of apertures comprises a combination of holes and cavities.

C14.6. The system of any of paragraphs C14-C14.5, wherein the geometry of at least one of the first aperture, the second aperture, or an aperture of the plurality of apertures is circular.

C14.7. The system of any of paragraphs C14-C14.5, wherein the geometry of at least one of the first aperture, the second aperture, or an aperture of the plurality of apertures is rectangular.

C14.7.1. The system of any of paragraphs C14-C14.5, wherein the geometry of at least one of the first aperture, the second aperture, or an aperture of the plurality of apertures is a square.

C14.7.2. The system of any of paragraphs C14-C14.5, wherein the geometry of at least one of the first aperture, the second aperture, or an aperture of the plurality of apertures has rounded corners.

C14.8. The system of any of paragraphs C14-C14.7.2, wherein the geometries of the first aperture, the second aperture, and the plurality of apertures is not uniform.

C14.9. The system of any of paragraphs C14-C14.8, wherein the sizes of the first aperture, the second aperture, and the plurality of apertures is not uniform.

C14.10. The system of any of paragraphs C14-C14.9, wherein the bifocal beamformer further comprises a first electrode configured to receive a first applied voltage.

C14.10.1. The system of paragraph C14.10, wherein the first electrode comprises a physical structure that at least partially defines an electrode entrance aperture that allows at least a portion of the plurality of charged particles to pass through the first electrode.

C14.10.1.1. The system of paragraph C14.10.1, wherein the electrode entrance aperture is a first electrode entrance aperture that allows a first portion of the plurality of charged particles to pass through the first electrode, and the second electrode further defines a second electrode entrance aperture that allows a second portion of the plurality of charged particles to pass through the first electrode.

C14.10.2. The system of any of paragraphs C14.10-C14.10.1.1, wherein the first electrode is upstream of the first aperture, the second aperture, and the plurality of apertures.

C14.10.3. The system of any of paragraphs C14.10-C14.10.2, wherein the first electrode is a disk shaped electrode.

C14.10.4. The system of any of paragraphs C14.10-C14.10.2, wherein the bifocal beamformer further comprises a second electrode configured to receive a second applied voltage.

C14.10.4.1. The system of paragraph C14.10.4, wherein the first voltage is different from the second voltage.

C14.10.4.2. The system of paragraph C14.10.4, wherein the first voltage and the second voltage are different.

C14.10.4.3. The system of any of paragraphs C14.10.4-C14.10.4.2, wherein the second electrode comprises a physical structure that at least partially defines an electrode exit aperture that at least one of the first charged particle beam and the second charged particle beam to pass through the second electrode.

C14.10.4.3.1. The system of paragraph C14.10.4.3, wherein the electrode exit aperture is a first electrode exit aperture that allows the first charged particle beam to pass through the second electrode, and the second electrode further comprises a second electrode exit aperture that allows the second charged particle beam to pass through the second electrode.

C14.10.4.3. The system of any of paragraphs C14.10.4-C14.10.4.3.1, wherein the second electrode is positioned downstream of the first aperture, the second aperture, and the plurality of apertures.

C15. The system of any of paragraphs C1-C11, wherein the bifocal beamformer comprises a biprism that defines a hole, and which is positioned and/or configured to split the plurality of charged particles into the first charged particle beam and the second charged particle beam.

C16. The system of any of paragraphs C1-C11, wherein laser pattern fringes are used to split the plurality of charged particles into the first charged particle beam and the second charged particle beam.

C17. The system of any of paragraphs C1-C16, wherein the second charged particle beam is focused at a different plane located above the sample.

C17.1. The system of paragraph C17, wherein the different plane is located at least at least 0.1%, 1%, 10%, or 100% of the objective lens focal distance above the sample.

C18. The system of any of paragraphs C1-C16, wherein the second charged particle beam is focused at a different plane located below the sample.

C18.1. The system of paragraph C18, wherein the different plane is located at least 0.1%, 1%, 10%, or 100% of the objective lens focal distance below the specimen the sample.

C19. The system of any of paragraphs C17-C18.1, wherein the distance between the plane at or near the sample and the different plane is at least 0.1%, 1%, 10%, or 100% of the objective lens focal distance.

C20. The system of any of paragraphs C1-C19, wherein the second charged particle beam is a parallel beam at the sample.

D1. Use of the system of any of paragraphs C1-C20 to perform any of the methods of paragraphs A1-A16, B1-B15, or L1-L10.2.

E1. A non-transitory computer readable media comprising instructions that, when executed by one or more processing units, cause the system of any of paragraphs C1-C20 to perform any of the methods of paragraphs A1-A16, B1-B15, or L1-L10.2.

F1. A MEMS device, comprising: a physical structure that defines: a first aperture configured to allow a first portion of charged particles of a plurality of charged particles to pass through the MEMS device; and a second aperture configured to allow a second portion of charged particles of the plurality of charged particles to pass through the MEMS device; and one or more electrodes configured to, when corresponding voltages are applied to the one or more electrodes, generate at least a quadrupole field that at least partially causes a modification of the focal properties of at least one of the first portion of charged particles and the second portion of charged particles.

F1.1. The MEMS device of paragraph F1, wherein the plurality of charged particles form a source beam that is incident on the MEMS device.

F1.1.1. The MEMS device of any of paragraphs F1-F1.1, wherein the plurality of charged particles are a plurality of electrons.

F2. The MEMS device of any of paragraphs F1-F1.1.1, wherein the first aperture is configured to form the first portion of charged particles into a first charged particle beam and the second aperture is configured to form the second portion of charged particles into a second charged particle beam.

F2.1. The MEMS device of paragraph F2, wherein the first aperture has the same radius as the second aperture.

F2.2. The MEMS device of paragraph F2, wherein the first aperture has a smaller radius than the second aperture.

F2.3. The MEMS device of paragraph F2, wherein the first aperture has a greater radius than the second aperture.

F3. The MEMS device of any of paragraphs F1-F2.3, wherein the physical structure comprises a surface layer that defines the first aperture and the second aperture.

F3.1. The MEMS device of paragraph F3, wherein the surface layer prevents a third portion of charged particles from passing through the MEMS device.

F3.2. The MEMS device of any of paragraphs F3-F3.1, wherein the surface layer is a foil.

F4. The MEMS device of any of paragraphs F1-F3.2, wherein the first aperture is an axial aperture positioned on an emission axis of the plurality of charged particles, and the second aperture is a non-axial aperture.

F5. The MEMS device of any of paragraphs F1-F3.2, wherein the second aperture is an axial aperture positioned on an emission axis of the plurality of charged particles, and the first aperture is a non-axial aperture.

F6. The MEMS device of any of paragraphs F1-F5, wherein at least one of the one or more electrodes is grounded.

F7. The MEMS device of any of paragraphs F1-F6 when dependent from any of paragraphs F3-F3.1, wherein the MEMS device comprises an insulating layer that is opposite the surface layer.

F7.1. The MEMS device of paragraph F7, wherein the one or more electrodes are located in an electrode layer positioned between the insulating layer and the surface layer.

F8. The MEMS device of any of paragraphs F1-F7.1, wherein the one or more electrodes comprise four electrodes.

F9. The MEMS device of any of paragraphs F1-F7.1, wherein the one or more electrodes comprise seven electrodes.

F10. The MEMS device of any of paragraphs F1-F9, wherein the at least the quadrupole field is one of a 12-field, 16-field, or 24-field.

F11. The MEMS device of any of paragraphs F1-F10, wherein the at least the quadrupole field does not cause the focal properties of the first charged particle beam to be changed.

F12. The MEMS device of any of paragraphs F1-F11, wherein the MEMS device is further configured to generate one or more dipole fields.

F12.1. The MEMS device of paragraph F12, wherein the one or more dipole fields cause at least one of the charged particle beams to be deflected in a direction perpendicular to the emission axis.

G1. Use of any of the MEMS devices of any of paragraphs F1-F12.1.

G2. Use of any of the MEMS devices of paragraphs F1-F12.1 to perform any of the methods of paragraphs A1-A16, B1-B15, or L1-L10.2.

G3. The use of any of the MEMS devices of paragraphs F1-F12.1 for investigation of a sample.

H1. Use of any of the MEMS devices of paragraphs F1-F12.1 in a system of any of paragraphs C1-C20.

I1. An aperture lens array device comprising: at least one physical structure that defines: a first aperture configured to allow a first portion of charged particles of a plurality of charged particles to pass through the aperture lens array device; a second aperture configured to allow a second portion of charged particles of the plurality of charged particles to pass through the aperture lens array device; plurality of other apertures; and at least one electrode, wherein the first aperture, the second aperture, and the plurality of other apertures form a pattern that, when corresponding voltages are applied to the at least one physical structure and at least one electrode, produces an electromagnetic field that applies a lensing effect to the second portion of charged particles during use of the aperture lens array device.

I1.1. The aperture lens array device of paragraph 11, wherein the plurality of charged particles form a source beam that is incident on the aperture lens array device.

I1.1.1. The aperture lens array device of any of paragraphs I1-I1.1, wherein the plurality of charged particles are a plurality of electrons.

I2. The aperture lens array device of any of paragraphs I.1-I1.1.1, wherein the first aperture is configured to form the first portion of charged particles into a first charged particle beam and the second aperture is configured to form the second portion of charged particles into a second charged particle beam.

I2.1. The aperture lens array device of paragraphs I2, wherein the electromagnetic field applies at least a quadrupole lensing effect to the second charged particle beam during use of the aperture lens array device.

I2.1.1. The aperture lens array device of paragraph I2.1, wherein the electromagnetic field does not apply the quadrupole lensing effect to the first charged particle beam during use of the aperture lens array device.

I2.1.2. The aperture lens array device of any of paragraphs I2-I2.1.1, wherein the electromagnetic field applies a circular lensing effect to the first charged particle beam during use of the aperture lens array device.

I2.1.3. The aperture lens array device of any of paragraphs I2-I2.1.2, wherein the electromagnetic field that at least a circular lensing effect to the second charged particle beam during use of the aperture lens array device.

I3. The aperture lens array device of any of paragraphs I1-I2.1.3, wherein the lensing effect applied by the electromagnetic field at least partially causes a modification of the focal properties of at least one of the first charged particle beam and the second charged particle beam.

I3.1. The aperture lens array device of paragraph I1, wherein the modification of the focal properties caused by the lensing effect causes the first charged particle beam and the second charged particle beam to have different focal properties.

I3.2. The aperture lens array device of any of paragraphs I3-I3.1, wherein the electromagnetic field does change the focal properties of the first charged particle beam.

I4. The aperture lens array device of any of paragraphs I1-I3.2, wherein at least one aperture of the plurality of apertures is a hole.

I4.1. The aperture lens array device of paragraph I4, wherein the hole comprises: an entrance defined in a first surface of the at least one physical structure, the first surface facing the plurality of charged particles; an exit defined in a second surface of the at least one physical structure that is opposite the first surface; and an empty volume that connects the entrance and the exit.

I4.1.1. The aperture lens array device of paragraph I4.1, wherein the first surface and the second surface are each surfaces of a single physical structure.

I4.1.2. The aperture lens array device of paragraph I4.1, wherein the first surface and the second surface are each surfaces of a different physical structures.

I5. The aperture lens array device of any of paragraphs I1-I4.1.2, wherein at least one aperture of the plurality of apertures is a cavity.

I5.1. The aperture lens array device of paragraph I5, wherein the cavity comprises: an entrance defined in a first surface of the at least one physical structure, the first surface facing the plurality of charged particles; and an empty volume in communication with the entrance and defined by the at least one physical structure, wherein the at least one physical structure defines the empty volume such that a charged particle of the plurality of charged particles that enters the empty volume via the entrance does not pass through the bifocal beamformer.

I5.1. The aperture lens array device of paragraph I5.1, wherein the cavity is defined by a single physical structure.

I5.2. The aperture lens array device of paragraph I5.1, wherein the cavity is defined by multiple physical structures.

I6. The aperture lens array device of any of paragraphs I4-I5.2, wherein the plurality of apertures comprises a combination of holes and cavities.

I7. The aperture lens array device of any of paragraphs I1-I6, wherein the geometry of at least one of the first aperture, the second aperture, or an aperture of the plurality of apertures is circular.

I8. The aperture lens array device of any of paragraphs I1-I7, wherein the geometry of at least one of the first aperture, the second aperture, or an aperture of the plurality of apertures is rectangular.

I9. The aperture lens array device of any of paragraphs I1-I8, wherein the geometry of at least one of the first aperture, the second aperture, or an aperture of the plurality of apertures is a square.

I10. The aperture lens array device of any of paragraphs I1-I9, wherein the geometry of at least one of the first aperture, the second aperture, or an aperture of the plurality of apertures has rounded corners.

I11. The aperture lens array device of any of paragraphs I1-I10, wherein the geometries of the first aperture, the second aperture, and the plurality of apertures is not uniform.

I12. The aperture lens array device of any of paragraphs I1-I11, wherein the sizes of the first aperture, the second aperture, and the plurality of apertures is not uniform.

I13. The aperture lens array device of any of paragraphs I1-I12, wherein the at least one electrode comprises a first electrode configured to receive a first applied voltage.

I13.1. The aperture lens array device of paragraph I13, wherein the first electrode comprises a physical structure that at least partially defines an electrode entrance aperture that allows at least a portion of the plurality of charged particles to pass through the first electrode.

I13.1.1. The aperture lens array device of paragraph I13.1, wherein the electrode entrance aperture is a first electrode entrance aperture that allows a first portion of the plurality of charged particles to pass through the first electrode, and the second electrode further defines a second electrode entrance aperture that allows a second portion of the plurality of charged particles to pass through the first electrode.

I13.2. The aperture lens array device of any of paragraphs I13-I13.1.1, wherein the first electrode is upstream of the first aperture, the second aperture, and the plurality of apertures.

I13.3. The aperture lens array device of any of paragraphs I13-I13.2, wherein the first electrode is a disk shaped electrode.

I13.4. The aperture lens array device of any of paragraphs I13-I13.3, wherein the at least one electrode further comprises a second electrode configured to receive a second applied voltage.

I13.4.1. The aperture lens array device of paragraph I13.4, wherein the first voltage is different from the second voltage.

I13.4.2. The aperture lens array device of paragraph I13.4, wherein the first voltage and the second voltage are the same.

I13.4.3. The aperture lens array device of any of paragraphs I13.4-I13.4.2, wherein the second electrode comprises a physical structure that at least partially defines an electrode exit aperture that at least one of the first charged particle beam and the second charged particle beam to pass through the second electrode.

I13.4.3.1. The aperture lens array device of paragraph I13.4.3, wherein the electrode exit aperture is a first electrode exit aperture that allows the first charged particle beam to pass through the second electrode, and the second electrode further comprises a second electrode exit aperture that allows the second charged particle beam to pass through the second electrode.

I13.4.4. The aperture lens array device of any of paragraphs I13.4-I13.4.3.1, wherein the second electrode is positioned downstream of the first aperture, the second aperture, and the plurality of apertures.

J1. Use of the multi-aperture device of any of paragraphs I1-I13.4.4.

J2. Use of the multi-aperture device of any of paragraphs I1-I13.4.4 to perform any of the methods of paragraphs A1-A16, B1-B15, or L1-L10.2.

J3. The use of the multi-aperture device of any of paragraphs I1-I13.4.4 for investigation of a sample.

K1. Use of the multi-aperture device of any of paragraphs I1-I13.4.4 in a system of any of paragraphs C1-C20.

L1. A method for investigating a sample with TEM and STEM techniques, the method comprising: emitting a plurality of electrons toward a sample; forming the plurality of electrons particles into a first electron beam and a second electron beam; modifying the focal properties of at least one of the first electron beam and the second electron beam such that: the first electron beam a STEM beam that is focused at a plane at or near the sample; and the second electron beam is a TEM beam that is parallel beam when incident on the sample; detecting emissions resultant from the STEM beam and the TEM beam being incident on the sample.

L2. The method of paragraph L1, further comprising generating one or both of a STEM image and TEM image from the detected emissions resultant from the STEM beam and the TEM beam being incident on the sample.

L3. The method of any of paragraph L1-L2, wherein detecting emissions resultant from the STEM beam and the TEM beam being incident on the sample comprises detecting (1) emissions resultant from the STEM beam being incident and (2) emissions resultant from the TEM beam being incident on the sample, using a same detector and/or detector array.

L4. The method of any of paragraph L1-L3, wherein detecting emissions resultant from the STEM beam and the TEM beam being incident on the sample comprises detecting (1) emissions resultant from the STEM beam being incident and (2) emissions resultant from the TEM beam being incident on the sample, at the same time.

L4.1. The method of paragraph L4, further comprising scanning the STEM beam across a surface region of the sample.

L4.1.1. The method of paragraph L4.1, wherein the TEM beam remains incident on the sample while the STEM beam is scanned.

L4.1.2. The method of any of paragraphs L4.1-L4.1.1, wherein the TEM beam remains incident on a static location while the STEM beam is scanned.

L5. The method of any of paragraph L1-L4.1, further comprising switching between two of a STEM mode of operation, a TEM mode of operation, and a simultaneous STEM/TEM mode of operation.

L5.1. The method of paragraph L5, wherein switching to the STEM mode of operation comprises causing the TEM beam to be blocked so that only the STEM beam is incident on the sample.

L5.1.1. The method of paragraph 5.1, wherein causing the TEM beam to be blocked comprises one of: deflecting the TEM beam so that it is blocked by a beam blocker; moving a beam blocker such that the beam blocker obstructs the path of the TEM beam; and obstructing an aperture so that the TEM beam cannot pass through the aperture.

L5.2. The method of any of paragraph L5-L5.1, wherein switching to the TEM mode of operation comprises causing the STEM beam to be blocked so that only the TEM beam is incident on the sample.

L5.2.1. The method of paragraph 5.2, wherein causing the STEM beam to be blocked comprises one of: deflecting the STEM beam so that it is blocked by a beam blocker; moving a beam blocker such that the beam blocker obstructs the path of the STEM beam; and obstructing an aperture so that the STEM beam cannot pass through the aperture.

L6. The method of any of paragraphs L1-L5.2.1., further comprising determining a portion of the detected emissions that is attributable to the TEM beam being incident on the sample.

L6.1. The method of paragraph L6, further comprising determining a portion of the detected emissions that is attributable to the STEM beam being incident on the sample.

L7. The method of any of paragraphs L1-L6.1, further comprising generating a STEM image based on the detected emissions resultant from the STEM beam and the TEM beam being incident on the sample.

L8. The method of any of paragraphs L1-L7, further comprising generating a TEM image based on the detected emissions resultant from the STEM beam and the TEM beam being incident on the sample.

L9. The method of any of paragraphs L1-L8, wherein the emissions resultant from the STEM beam and the TEM beam being incident on the sample are detected with a single detector and/or detector array.

L10. The method of any of paragraphs L1-L9, wherein the forming of the plurality of electrons particles into a first electron beam and a second electron beam and the modification of the focal properties is performed at least in part by a bifocal beamformer.

LI0.1. The method of paragraph L10, wherein the bifocal beamformer is a MEMS device of any of paragraphs F1-F12.1.

L10.2. The method of paragraph L10, wherein the bifocal beamformer is a multi aperture array of any of paragraphs I1-113.4.4.

L10.2. The method of any of paragraphs L10-L10.2, wherein the bifocal beamformer applies at least a quadrupole lensing effect to one of the first electron beam and the second electron beam.

**Claims**

1. A system for investigating a sample, the system comprising:

   a sample holder 130 configured to hold the sample 104;
   a charged particle emitter 106 configured to emit a plurality of charged particles 108 towards the sample;
   a bifocal beamformer 112 positioned between the charged particle emitter and the sample holder, wherein the bifocal beamformer is configured to:

   form the plurality of charged particles into a first charged particle beam and a second charged particle beam; and
   modify one or more focal properties of at least one of the first charged particle beam and the second charged particle beam such that the first charged particle beam is focused at a plane at or near the sample and the second charged particle beam is not focused at the plane at or near the sample.

2. The system of claim 1, wherein the charged particle emitter is an electron emitter configured to emit electrons toward the sample, and the first charged particle beam and the second charged particle beam are each electron beams.

3. The system of any of claims 1 or 2, wherein a second beam diameter of the second charged particle beam at the sample is at least 50 times greater than a first beam diameter of the first charged particle beam at the sample.

4. The system of any of claims 1 or 2, wherein the bifocal beamformer modifies the focal properties by applying at least a quadrupole lensing effect to at least one of the first charged particle beam and the second charged particle beam.

5. A method for investigating a sample, the method comprising:

   emitting a plurality of charged particles 108 toward the sample 104;
   forming the plurality of charged particles into a first charged particle beam 114 and a second charged particle beam 116;
   modifying the focal properties of at least one of the first charged particle beam and the second charged particle beam such that the corresponding focal planes of the first charged particle beam and the second charged particle beam are different.

6. The method of claim 5, wherein the plurality of charged particles are electrons and the first charged particle beam and the second charged particle beam are each electron beams.

7. The method of claim 5, wherein a second beam diameter of the second charged particle beam in a plane where the first beam diameter has a crossover is at least one of 50 times greater than a first beam diameter of the first charged particle beam in the same plane.

8. The method of claim 5, wherein the first charged particle beam and the second charged particle beam are mutually coherent beams.

9. The method of any of claims 5-8, wherein each of the forming the plurality of charged particles and the modifying of the focal properties is at least partially performed by a bifocal beamformer.

10. The method of claim 9, wherein the bifocal beamformer applies at least a quadrupole lensing effect to the first charged particle beam.

11. The method of claim 10, wherein the modifying of the focal properties is at least partially performed by a multipole positioned downstream of the bifocal beamformer, wherein the multipole is positioned at a focal plane of the second charged particle beam, and wherein the multipole is configured to apply at least a quadrupole lensing effect to the first charged particle beam.

12. The method of claim 9, wherein the bifocal beamformer is further configured to deflect at least one of the first charged particle beam and the second charged particle beam away from an emission axis of the plurality of charged particles.

13. The method of claim 9, wherein the bifocal beamformer comprises a MEMS device configured to generate at least a quadrupole field that at least partially causes the modifying of the focal properties of at least one of the first charged particle beam and the second charged particle beam.

14. The method of claim 13, wherein the MEMS device comprises a structure defining a first aperture and a second aperture, and wherein the first charged particle beam passes through the first aperture and the second charged particle beam passes through the second aperture.

15. The method of claim 13, wherein the MEMS device comprises one or more electrodes configured to generate the at least the quadrupole field when corresponding voltages are applied to the one or more electrodes.

16. The method of claim 9, wherein the bifocal beamformer comprises:

a physical structure defining a first aperture and a second aperture, wherein the first charged particle beam passes through the first aperture and the second charged particle beam passes through the second aperture; and
a lens positioned and/or configured to adjust the focal properties of the at least one of the first charged particle beam and the second charged particle beam such that they have different corresponding focal planes.

17. The method of claim 9, wherein the bifocal beamformer comprises at least one physical structure that defines:

a first aperture that allows the first charged particle beam to pass through the at least one physical structure;
a second aperture that allows the second charged particle beam to pass through the at least one physical structure; and
plurality of other apertures.

18. The method of claim 17, wherein the first aperture, the second aperture, and the plurality of other apertures form a pattern that creates an electromagnetic field that applies at least a quadrupole lensing effect to the second charged particle beam during use of the bifocal beamformer.

19. The method of claim 18, wherein the lensing effect applied by the electromagnetic field at least partially causes the modifying of the focal properties of at least one of the first charged particle beam and the second charged particle beam.

20. The method of claim 5, wherein the one of the first charged particle beam and the second charged particle beam is a parallel beam at the sample.

**FIG. 1**

200

202
Cause a Plurality of Charged Particles
to be Emitted Toward a Sample

204
Form the Plurality of Charged Particles
into a First Charged Particle Beam and
a Second Charged Particle Beam

206
Modify the Focal Properties of at Least
one of the First Charged Particle Beam
and the Second Charged Particle Beam

208
Focus one of the Charged Particle
Beams at a first plane on or near the
Sample

210
Focus the other Charged Particle Beam
at a second plane that is not at or near
the Sample

212
Detect Information Resultant from the
Charged Particle Beams interacting
with the Sample

214
Generate an Image and/or
Compositional Information about
the Sample

# FIG. 2

**FIG. 3**

400

300

414

418

402

402

408

410

L

412

416    404

406

420

# FIG. 4

500

300

502    D    504

506

$R_{E1}$

$R_{A1}$

414

418

$R_{A1}$

$R_{E1}$

508

# FIG. 5

**FIG. 6**

**FIG. 7**

**FIG. 8**

FIG. 9

**FIG. 10**

**FIG. 11**

**FIG. 12**

**FIG. 13**

**FIG. 14**

**FIG. 15**

**FIG. 16**

FIG. 17

FIG. 18

FIG. 19

FIG. 20

**FIG. 21**

**FIG. 22**

**FIG. 23**

**FIG. 24**

| | Europäisches Patentamt<br>European Patent Office<br>Office européen des brevets | **EUROPEAN SEARCH REPORT** | Application Number<br>EP 21 16 4758 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/149833 A1 (ENDOH HISAMITSU [JP] ET AL) 26 June 2008 (2008-06-26)<br>* paragraphs [0040] - [0079]; figures 3-6 * | 1-20 | INV.<br>H01J37/04<br>H01J37/26 |
| X | DATABASE INSPEC [Online]<br>THE INSTITUTION OF ELECTRICAL ENGINEERS, STEVENAGE, GB;<br>1978,<br>BEAUMONT S P ET AL: "Combined CTEM and STEM using a condenser-objective lens and 100 kV LaB6 gun",<br>XP002803978,<br>Database accession no. 1570919<br>* abstract *<br>& ELECTRON MICROSCOPY 1978. NINTH INTERNATIONAL CONGRESS ON ELECTRON MICROSCOPY,<br>vol. I, August 1978 (1978-08), pages 2-3, Electron Microscopy 1978. Ninth International Congress on Electron Microscopy Microscopical Soc. Canada Toronto, Ont., Canada<br>ISBN: 0-920622-06-2 | 1-7, 9-11,20 | |
| X | US 2017/084424 A1 (MASNAGHETTI DOUG K [US] ET AL) 23 March 2017 (2017-03-23)<br>* figs. 1 to 7 and related text * | 1-6,9-20 | |
| X | US 2014/110577 A1 (LECHNER LORENZ [DE]) 24 April 2014 (2014-04-24)<br><br>* figs. 2, 4 5 and related text * | 5,7, 9-11,16, 17,20 | |
| X | US 2010/133433 A1 (TANIMOTO SAYAKA [JP] ET AL) 3 June 2010 (2010-06-03)<br>* figs. 9, 10, 11, 13 and related text * | 1-7,9-19 | |

| | TECHNICAL FIELDS SEARCHED (IPC) |
|---|---|
| | H01J |

The present search report has been drawn up for all claims

| Place of search | Date of completion of the search | Examiner |
|---|---|---|
| Munich | 18 August 2021 | Krauss, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 16 4758

This annex lists the patent family members relating to the patent documents cited in the above-mentioned European search report.
The members are as contained in the European Patent Office EDP file on
The European Patent Office is in no way liable for these particulars which are merely given for the purpose of information.

18-08-2021

| Patent document cited in search report | | Publication date | Patent family member(s) | | Publication date |
|---|---|---|---|---|---|
| US 2008149833 | A1 | 26-06-2008 | EP 1852890 | A1 | 07-11-2007 |
| | | | JP 4807592 | B2 | 02-11-2011 |
| | | | JP WO2006088159 | A1 | 03-07-2008 |
| | | | US 2008149833 | A1 | 26-06-2008 |
| | | | WO 2006088159 | A1 | 24-08-2006 |
| US 2017084424 | A1 | 23-03-2017 | NONE | | |
| US 2014110577 | A1 | 24-04-2014 | DE 102012020478 | A1 | 08-05-2014 |
| | | | EP 2722661 | A2 | 23-04-2014 |
| | | | JP 6619043 | B2 | 11-12-2019 |
| | | | JP 2014089956 | A | 15-05-2014 |
| | | | JP 2018141791 | A | 13-09-2018 |
| | | | US 2014110577 | A1 | 24-04-2014 |
| US 2010133433 | A1 | 03-06-2010 | JP 5227512 | B2 | 03-07-2013 |
| | | | JP 2008165990 | A | 17-07-2008 |
| | | | US 2010133433 | A1 | 03-06-2010 |

EPO FORM P0459

For more details about this annex : see Official Journal of the European Patent Office, No. 12/82